# EUROPÄISCHE PATENTSCHRIFT

(11) **EP 2 171 017 B1**
(45) Veröffentlichungstag und Bekanntmachung des Hinweises auf die Patenterteilung: **29.08.2012**
(21) Anmeldenummer: 08775336.4
(22) Anmeldetag: 24.07.2008
(51) Int. Cl.: C09K 11/59, H01J 61/44

(54) **TEMPERATURSTABILER OXYNITRID-LEUCHTSTOFF UND LICHTQUELLE MIT DERARTIGEM LEUCHTSTOFF**
TEMPERATURE-STABLE OXYNITRIDE PHOSPHOR AND LIGHT SOURCE COMPRISING A CORRESPONDING PHOSPHOR MATERIAL
SUBSTANCE LUMINESCENTE À OXYNITRURE THERMOSTABLE ET SOURCE LUMINEUSE CONTENANT CE TYPE DE SUBSTANCE LUMINESCENTE

(30) Priorität: 30.07.2007 DE 102007035592
(43) Veröffentlichungstag der Anmeldung: 07.04.2010
(73) Patentinhaber: OSRAM AG, 81543 München (DE)
(72) Erfinder: BECKER, Daniel, 86199 Augsburg (DE); JERMANN, Frank, 86343 Königsbrunn (DE); POHL, Bianca, 81379 München (DE); HEMPEL, Wolfram, 71397 Leutenbach (DE)
(86) Internationale Anmeldenummer: PCT/EP2008/059726
(87) Internationale Veröffentlichungsnummer: WO 2009/016096

(56) Entgegenhaltungen:
- EP-A- 1 595 934
- EP-A- 1 985 683
- WO-A-2006/035991
- WO-A-2007/018260
- WO-A-2007/068592
- JP-A- 2006 124 674

## Beschreibung

### Technisches Gebiet

Die Erfindung geht aus von einem temperaturstabilen Leuchtstoff, bevorzugt zum Einsatz bei Lichtquellen, gemäß dem Oberbegriff des Anspruchs 1. Die Erfindung betrifft einen hocheffizienten Leuchtstoff aus der Klasse der Sione gemäß dem Oberbegriff des Anspruchs 1. Weiter betrifft die Erfindung eine damit hergestellte Lichtquelle und ein Verfahren zur Herstellung eines derartigen Leuchtstoffs.

### Stand der Technik

EP-A 1 413 618 offenbart einen Leuchtstoff, der aus der Klasse der Oxinitride stammt und die Zusammensetzung MSi202N2:Eu aufweist. Dabei ist M vornehmlich Ca, Ba oder Sr und der Aktivator Z vornehmlich Eu. Sie werden hier als Sione bezeichnet. Dieser Leuchtstoff ist im UV und blauen Spektralbereich gut anregbar. Er eignet sich für Lichtquellen wie LEDs. Ein ähnlicher Leuchtstoff ist in EP 1985683 offenbart.

### Darstellung der Erfindung

Die Aufgabe der vorliegenden Erfindung ist es, einen schmalbandigen, temperaturstabilen Leuchtstoff, der vorzugsweise im Grünen emittiert, anzugeben. Dabei soll der Leuchtstoff zur Verwendung mit UV- und Blau-LEDs besonders geeignet sein. Aber auch andere Anwendungen sind nicht ausgeschlossen.

Diese Aufgabe wird gelöst durch kennzeichnenden Merkmale des Anspruchs 1.

Besonders vorteilhafte Ausgestaltungen finden sich in den abhängigen Ansprüchen.

Die bisher bekannten Systeme zeichnen sich im Fall der Nitride durch sehr hohe Effizienz und Temperaturstabilität aus. Allerdings sind derzeit noch keine effizienten, schmalbandig emittierende Systeme mit einer PeakWellenlänge bei 525 - 535 nm bekannt. Die grünen Orthosilikate und Thiogallate emittieren zwar schmalbandig und bei Zimmertemperatur auch sehr effizient, besitzen aber ein sehr schlechtes Temperaturverhalten. Das heißt, ihre Lumineszenzeffizienz LE sinkt sehr stark mit zunehmender Temperatur (typisch ist LE < 10% bei 225 °C). Allerdings ist die Temperaturstabilität der Lumineszenz schlechter als bei den Nitriden. Außerdem ist eine kurzwelligere Emission in bestimmten Anwendungen wünschenswert, insbesondere um einen höheren visuellen Nutzeffekt zu erzielen.

Für viele Anwendungen, z. B. in LCD-Backlights oder für RPTV (rear projection television), werden blau- oder im nahen UV anregbare, sehr temperaturstabile Leuchtstoffe mit einer Peakwellenlänge zwischen 525 und 535 nm benötigt. Diese Wellenlänge passt ideal zu den üblichen Farbfiltern und ermöglicht eine gute Farbwiedergabe. Die gute Temperaturstabilität ist notwendig, da sich der Leuchtstoff bedingt durch hohe Chip-Temperaturen bei hohen Leistungen und bedingt durch im Leuchtstoffkorn entstehende Wärme bei hohen Strahlungsflüssen stark erwärmen kann. Dabei können sich Temperaturen bis 200 °C ergeben.

Ursache des zweiten Erwärmungsmechanismus ist der sogenannte Stokes-Shift, also die Energiedifferenz zwischen absorbiertem und emittiertem Photon, die im Leuchtstoff in Wärme umgesetzt wird.

Bisher gibt es keinen einzigen bekannten, schmalbandigen Grünleuchtstoff, der auch bei hohen Temperaturen, vorzugsweise mindestens 125 °C, insbesondere bei mindestens 175°C, noch hohe Effizienzen aufweist, und zwar mindestens 80%, insbesondere sogar mindestens 90% der Effizienz bei Raumtemperatur. Mit schmalbandig ist eine FWHM von höchstens 70 nm gemeint. Mit Grünleuchtstoff ist ein Leuchtstoff gemeint, dessen Peakwellenlänge im Bereich 520 bis 540 nm liegt, insbesondere in einem Bereich von 525 bis 535 nm.

Es wurde ein völlig neuartiger Leuchtstoff im Phasensystem BaO-SiO2-Si3N4 entdeckt. Dieser Leuchtstoff unterscheidet sich vom bekannten BaSi202N2 durch einen wesentlich höheren Sauerstoffgehalt und von den bekannten Silikaten wie Ba2Si04, BaSi205 und BaSi03 durch einen signifikanten Anteil an Stickstoff im Wirtsgitter. Die neue Phase weist ein von allen bekannten Silikaten und SiONen abweichendes XRD-Reflexmuster auf. Letzteres lässt auf eine hohe Symmetrie der neuen Verbindung schließen. Die Ansatzstöchiometrie kann bevorzugt bei einem Ausführungsbeispiel durch Ba9Si21036N10 beschrieben werden.

Der Aktivator D, der Ba ersetzt, ist dabei bevorzugt entweder Eu allein oder zusammen mit Yb. Der Anteil des Yb sollte aber nicht höher als 10 Mol.-% von D sein, bevorzugt im Bereich von 1 bis 5% Anteil.

Der neuartige Leuchtstoff weist gegenüber bekannten grünen Leuchtstoffen wie dem (Sr,Ba)2SiO4:Eu (Orthosilikat) bzw. SrGa2(S,Se)4:Eu (Thiogallat-Typ) eine erheblich bessere Temperaturstabilität auf. Während die besten auf dem Markt erhältlichen Orthosilikate bei 175°C noch ca. 25-30% ihrer Raumtemperatur-Effizienz aufweisen, liegt die neue Verbindung hier bei 80-90% und stellt damit einen technologischen Durchbruch dar.

Der neuartige Leuchtstoff zeigt sehr gute thermische u. chem. Stabilität. Er lässt sich sehr gut für beispielsweise Weiße LEDs, Color-On-Demand (COD), RPTV/TV-Backlighting-LEDs und elektrische Lampen wie Leuchtstofflampen anwenden.

Angegeben wird weiterhin ein Herstellverfahren für den neuartigen Leuchtstoff.

### Kurze Beschreibung der Zeichnungen

Im Folgenden soll die Erfindung anhand eines Ausführungsbeispiels näher erläutert werden. Die Figuren zeigen:
- Figur 1: die Stabilität der Effizienz eines neuartigen Leuchtstoffs gegenüber dem thermischen Löschen;
- Figur 2: die XRD-Reflexe eines neuartigen Leuchtstoffs;
- Figur 3: eine Übersicht über das Phasendiagramm des Systems der Edukte BaC03-SiN4/3-Si02 mit 2% Eu für Ba;
- Figur 4: die Emissionsspektren bei der Ansatzstöchiometrie Ba2-xEuxSi509N2 für verschiedene Eu-Konzentrationen;
- Figur 5: Emissionsspektren bei der Ansatzstöchiometrie Ba2-x-ySryEuxSi4,6O9,2N1,8;
- Figur 6: die Emissionsspektren bei verschiedenen Ansatzstöchiometrien;
- Figur 7: die Pulverhelligkeit als Funktion der Aktivatorkonzentration bei 400 nm Anregung;
- Figur 8: die Pulverhelligkeit als Funktion der Aktivatorkonzentration bei 460 nm Anregung;
- Figur 9: die Anregbarkeit des neuen Ba-SiONs bei verschiedener Eu-Konzentration;
- Figur 10: die Anregbarkeit des neuen Ba-SiONs für verschiedene Ansatzmischungen;
- Figur 11: den prinzipiellen Aufbau einer Lichtquelle für grünes Licht;
- Figur 12: den prinzipiellen Aufbau einer Lichtquelle für weißes Licht;
- Figur 13: den prinzipiellen Aufbau einer Entladungslampe;
- Figur 14: das Emissionsspektrum einer Tb3+-dotierten Probe des Leuchtstoffs (Ba_{0,95}Tb_{0,05})₂Si₅O₉N₂;
- Figur 15: das Emissionsspektrum einer Ce3+-dotierten Probe des Leuchtstoffs (Ba_{0,98}Ce_{0,02})₂Si₅O₉N₂;
- Figur 16: das Anregungsspektrum einer Ce3+-dotierten Probe des Leuchtstoffs (Ba_{0,98}Ce_{0,02})₂Si₅O₉N₂.
- Figur 17: ein Vergleich der Pulverhelligkeit bei reiner EU-Dotierung und Kodotierung mit Yb.
- Figur 18: ein Vergleich der Pulverhelligkeit für verschiedene Ansatzstöchiometrien,
- Figur 19: ein Vergleich der Pulverhelligkeit als Funktion der Haltezeit;
- Figur 20: die Pulverhelligkeit als Funktion des Schmelzmittelzusatzes.
- Figur 21: eine Übersicht über das Phasendiagramm des Systems der Edukte BaC03-SiN4/3-Si02 mit 2% Eu für Ba unter Darstellung besonders geeigneter Leuchtstoffe.

### Bevorzugte Ausführung der Erfindung

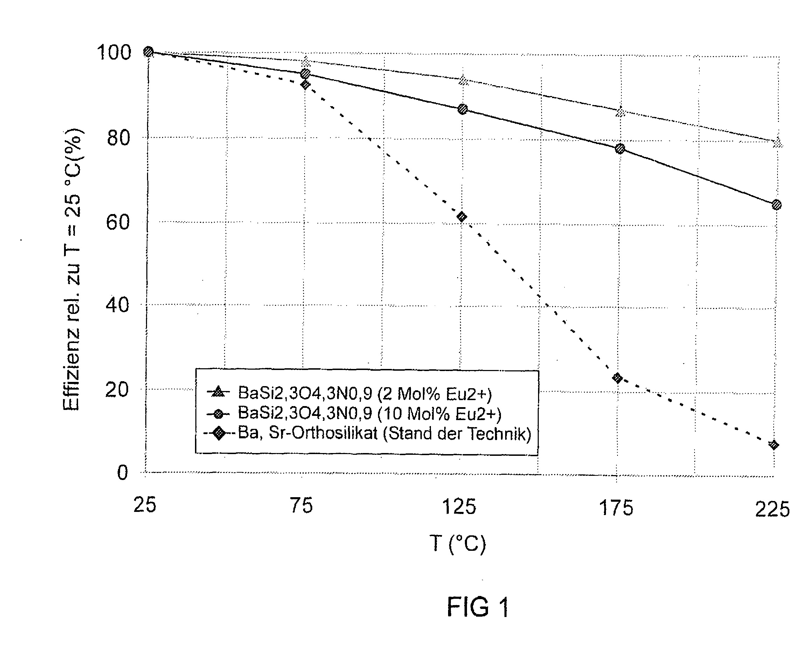

Figur 1 zeigt die Stabilität der Effizienz gegenüber dem thermischen Löschen. Die neu entdeckte Leuchtstoffphase besitzt eine gegenüber allen anderen bekannten schmalbandig bei etwa 525 bis 535 nm emittierenden, meist Eu2+-aktivierten Systemen eine überragende Temperaturstabilität der Emission. Figur 1 zeigt einen Vergleich zwischen der erfindungsgemäßen Ba-SiON-Phase und einem SrBa-Orthosilikat mit ähnlicher Emission, welches den besten Stand der Technik darstellt.

Ein konkreter neuartiger Leuchtstoff ist BaSi2,3O4,3N0,9:Eu(2%) = Ba2Si4,6O8,6N1,8:Eu(2%) . Dessen Herstellung soll nachfolgend näher beschrieben werden.

Die Ausgangsstoffe 11,784 g BaC03, 6,102 g SiO2, 1,900 g Si3N4 und 0,214 g Eu203 werden, evtl. unter Zugabe üblicher Schmelzmittel, mehrere Stunden lang, insbesondere 2 bis 8 Stunden lang, homogenisiert.

Die Ansatzmischung wird in Al2O3-Tiegeln mit Deckel unter reduzierenden Bedingungen, bevorzugt Formiergas, bei etwa 1200 bis 1400°C für mehrere Stunden, insbesondere 3 bis 10 Stunden, geglüht. Mit reduzierenden Bedingungen ist die Verwendung von Inertgas, bevorzugt N2 unter Zugabe von H2 gemeint. Der Anteil des H2 am Formiergas soll dabei bei 0 bis 20 % (Randwerte eingeschlossen) liegen, beispielsweise werden 4 % H2 verwendet.

Der Glühkuchen wird in üblicher Weise gemahlen und das Leuchtstoff-Pulver dann ggf. einer zweiten Glühung bei 850 bis 1450°C unter reduzierenden Bedingungen (Formiergas) unterzogen. Der Anteil des H2 am Formiergas soll dabei bei 0 bis 20 % (Randwerte eingeschlossen) liegen, beispielsweise werden 4 % H2 verwendet.

In einem zweiten Ausführungsbeispiel ist das Herstellverfahren ähnlich, jedoch wird für die Zielstöchiometrie Ba2Si509N2 folgende Einwaage der Ausgangsstoffe gewählt:
11,473 g BaC03, 6,238 g Si02, 2,081 g Si3N4 und 0,209 g Eu2O3.

In einem dritten Ausführungsbeispiel ist das Herstellverfahren ähnlich, jedoch wird für eine bevorzugte Zielstöchiometrie Ba9Si21036N10 folgende Einwaage der Ausgangsstoffe gewählt:
11,864 g BaC03, 5,529 g Si02, 2,391 g Si3N4 und 0,216 g Eu203.

Vorteilhaft ist der Einsatz typischer Schmelzmittel wie Fluoride, Chloride und Oxide (siehe Tab. 1). Konkrete Ausführungsbeispiele sind BaF₂ oder auch BaCl₂. sowie weitere in Tab. 1 untersuchte Verbindungen.

Die Ansatzstöchiometrie ist nicht identisch mit der Produktstöchiometrie, dient aber als grober Anhaltspunkt. Beispielsweise führt die Ansatzstöchiometrie BaSi2,3O4,3N0,9 gemäß Elementaranalyse zu einem Leuchtstoff der ungefähren Produktstöchiometrie Ba2Si509N2. Die Indices der Produktstöchiometrien wie sei hier angegeben sind, sind im allgemeinen typisch auf 10% genau, wenn man als Fixpunkt den Index für Ba nimmt.

**Tab. 1**

| Probe BPxx/07 | Flussmittel (additiv) | Rel. QE | Rel. Helligkeit |
|---|---|---|---|
| 230 | ohne | 100% | 100% |
| 311 | 2 mol% H3B03 | 102% | 122% |
| 312 | 2 mol% NH4Cl | 102% | 119% |
| 313 | 2 mol% BaF2 | 111% | 131% |
| 314 | 2 mol% La2O3 | 102% | 119% |

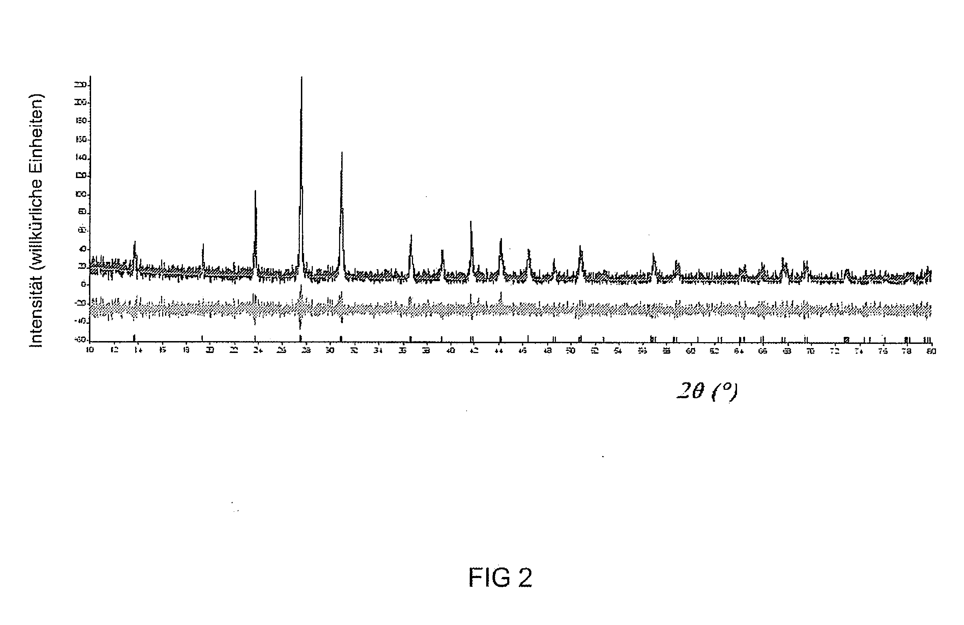

Figur 2 zeigt die XRD-Reflexe des neuartigen Leuchtstoffs. Am besten gelingt die Beschreibung der XRD-Reflexe der neuen Phase mit einer trigonalen bzw. hexagonalen Raumgruppe mit a = 7, 5094 (1) 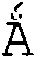 und c = 6, 4753 (1) 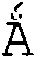 mit einem Zellvolumen V = 316,23 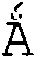 ³. Eine widerspruchsfreie Beschreibung der Bariumlagen unter Berücksichtigung der Volumeninkremente möglicher Zusammensetzung führen auf die Raumgruppe P3 bzw P-3.

Tab. 2 zeigt die Reflexe mit Lage der Reflexe mit Netzebenenabständen dₕₖₗ und abgeschätzte Peakintenistäten. Die Fehler in den Netzebenenabständen können bis zu +-2% betragen.

**Tab. 2: Reflexlagen und Intensitäten**

| Reflex-Nr. | dₕₖₗ (A) | Intensität |
|---|---|---|
| 1 | 6,49 | Mittel |
| 2 | 4,59 | Mittel |
| 3 | 3,75 | Stark |
| 4 | 3,25 | Stark |
| 5 | 2,90 | Stark |
| 6 | 2,45 | Mittel |
| 7 | 2,30 | Mittel |
| 8 | 2,16 | Mittel |
| 9 | 2,05 | Mittel |
| 10 | 1,96 | Mittel |
| 11 | 1,87 | Schwach |
| 12 | 1,80 | Mittel |
| 13 | 1,62 | Mittel |
| 14 | 1,58 | Schwach |
| 15 | 1,45 | Schwach |
| 16 | 1,42 | Schwach |
| 17 | 1,38 | Schwach |
| 18 | 1,35 | Schwach |
| 19 | 1,30 | Schwach |
| 20 | 1,27 | Schwach |
| 21 | 1,25 | Schwach |
| 22 | 1,23 | Schwach |
| 23 | 1,21 | Schwach |

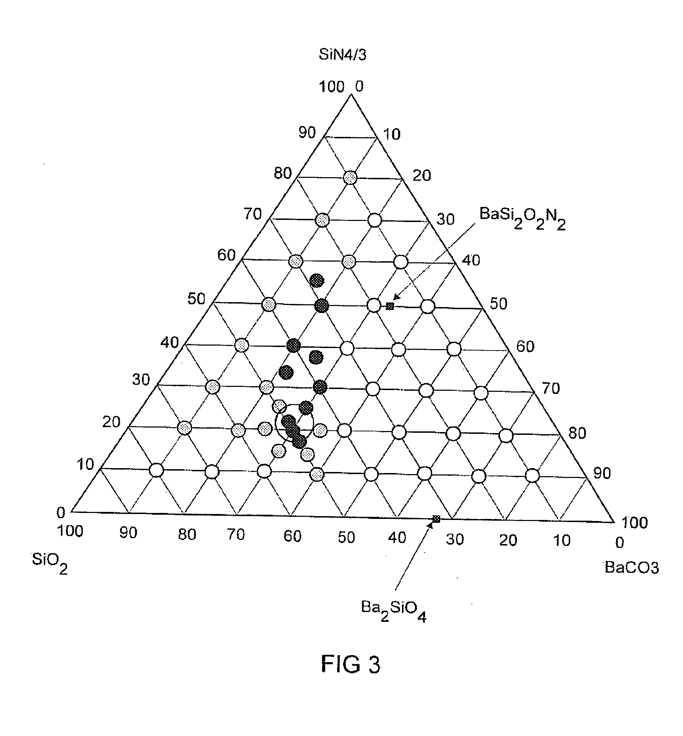

Figur 3 zeigt eine Übersicht über das Phasendiagramm des Systems der Edukte BaC03-SiN4/3-Si02 mit 2% Eu für Ba.

Die zwei wichtigsten bereits bekannten Leuchtstoffphasen in diesem System sind:
- das blaugrüne BaSi2O2N2:Eu sowie das blaugrüne Ba2SiO4:Eu. Diese beiden sind mit Pfeilen gekennzeichnet. Beide Systeme zeigen ein deutlich schlechteres Temperaturverhalten als der erfindungsgemäße Leuchtstoff. Der Kreis kennzeichnet den Bereich besonders hoher Effizienz der neuen Phase. Nahezu oder vollständig reinphasige neuartige Leuchtstoffe sind mit einem schwarzen Kreis gekennzeichnet, Mischphasen mit anderen Phasen mit einem schraffierten Kreis und alleine andere Phasen mit einem weißen Kreis. Die anderen Phasen sind je nach Ansatzstöchiometrie Si3N4, Ba-Orthosilikat, Si02, Ba2Si5N8, Ba-SiO3, BaSi2O5, BaO, Ba3Si05 sowie Ba2Si3O8. Gute Ergebnisse für die neuartige Phase liefert eine Ansatzstöchiometrie, die etwa in einem Quadrat mit den folgenden Eckpunkten liegt:
   (1) SiO2 : SiN4/3 : BaCO3 = 0,525 : 0,25 : 0,225 (entspricht Bal.8Si6.2O10.2N2.67);
   (2) SiO2 : SiN4/3 : BaCO3 = 0,425 : 0,25 : 0,325 (entspricht Ba2.6Si5.4O9.4N2.67);
   (3) SiO2 : SiN4/3 : BaCO3 = 0,475 : 0,15 : 0,375 (entspricht Ba3Si5O10.6N1.6);
   (4) SiO2 : SiN4/3 : BaCO3 = 0,575 : 0,15 : 0,275 (entspricht Ba2.2Si5.8O11.4N1.6).

Die neuartige Phasenzusammensetzung ist besonders reinphasig ausgeprägt, wenn das BaC03:Si02-Verhältnis bei den Ansatzmischungen zwischen 1:1,5 und 1:2 beträgt. Dazu wird dann SiN4/3 zugemischt. Insgesamt sollte der SiN4/3-Anteil mindestens 15 % betragen, maximal 55 %. Die besten Proben ergeben sich bei 20 - 30 % SiN4/3.

Tab. 3 zeigt ein Screening des Phasenraums, wobei die Leuchtstoffeffizienzen, die Farbörter und die dominante Emissionswellenlänge für 400 nm Anregung bei 2% Eu-Aktivatorkonzentration (Substitution of Ba-Platz) angegeben sind.

Die neue Phase emittiert, bei einer Dotierung von 2% Eu, typischerweise bei etwa λdom = 537 ± 3 nm. Alle anderen bekannten reinen Eu-dotierten Ba-Silikate und Ba-SiONe emittieren deutlich kurzwelliger. Es wird hierzu auf Probe BP128/07 verwiesen, die nur Ba-Orthosilikat als leuchtende Verbindung zeigt. Der Leuchtstoff BaSi2O2N2:Eu (ca. 500 nm) entsteht bei den gewählten Synthesebedingungen - insbesondere bei dieser niedrigen Temperatur - erst gar nicht.

Tab. 4a/4b zeigt die Effizienzen ausgewählter Ansatzstöchiometrien (hohe Phasenreinheit) für verschiedene Eu-Konzentrationen und zwar für 400 bzw. 460 nm Anregungswellenlänge.

Eine zweite Glühung (Proben mit Index 'a') verbessert im allgemeinen die Kristallinität und erhöht so die Effizienz der Proben. Bei 460 nm Anregung sind i. allg. etwas höhere Eu-Konzentrationen vorteilhaft. Dies deckt sich mit dem Befund bei Untersuchung der Anregungsspektren.

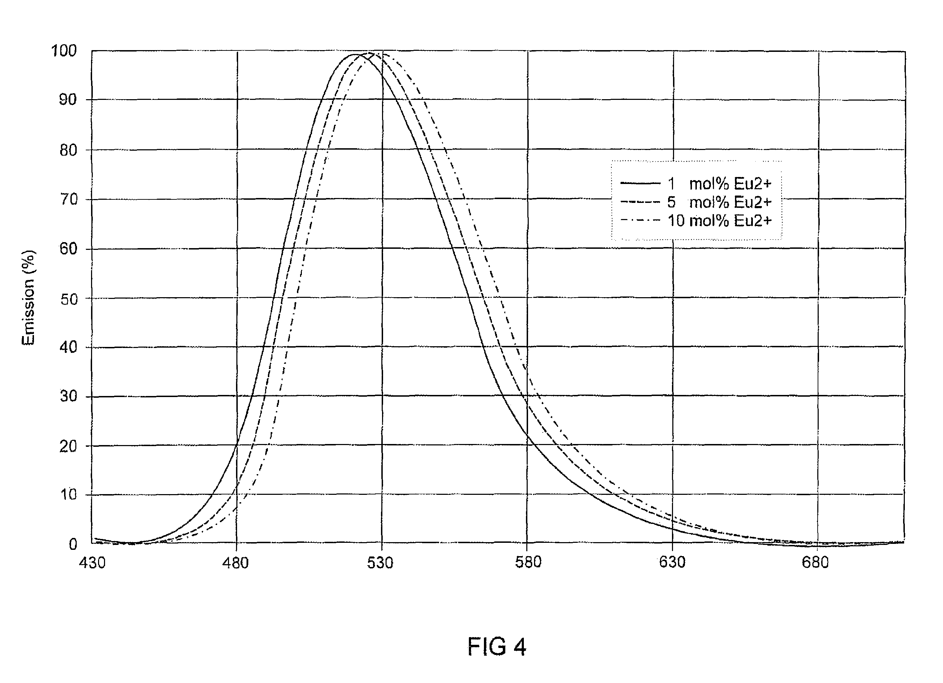

Figur 4 zeigt die Emissionsspektren bei der Ansatzstöchiometrie Ba2-xEuxSi5O9N2 für verschiedene Eu-Konzentrationen im Bereich x = 0,02 bis x = 0,2. Dies entspricht 1, 5 und 10 Mol.-% von M. Es sind aber durchaus auch höhere Konzentrationen an Eu möglich.

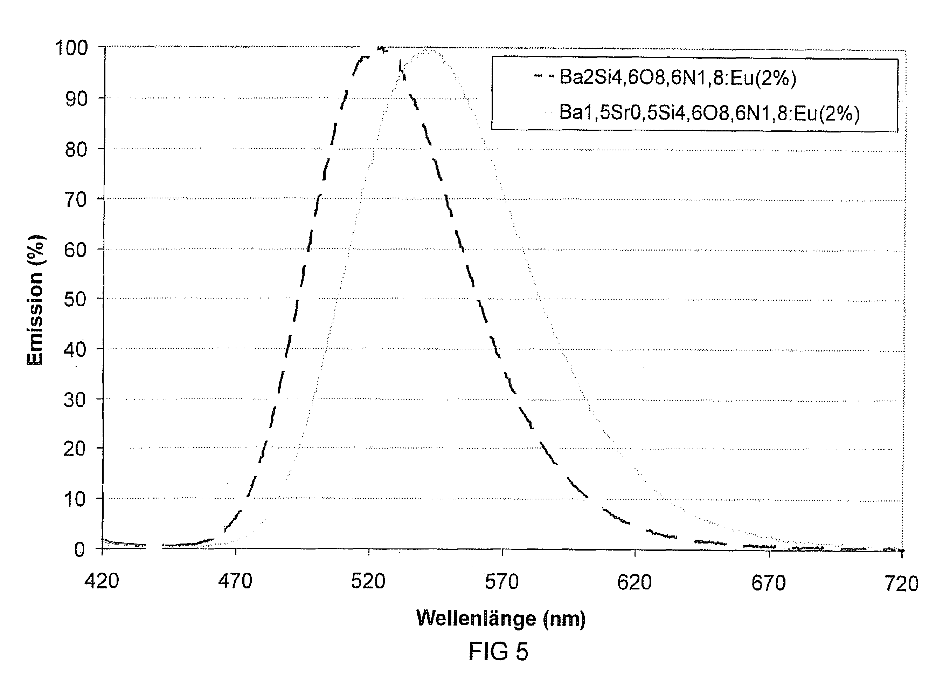

Figur 5 zeigt Emissionsspektren bei der Ansatzstöchiometrie Ba2-x-ySryEuxSi4,609,2N1,8 für festes x = 0,04 (2% Eu) bei y = 0 bzw. y = 0,48 (ca. 25% Sr für Ba). Erwartungsgemäß führt der Einbau eines kleineren Ions wie Sr zu einer langwelligeren Emission. Ein kleineres Ion führt zu einer stärkeren Wechselwirkung mit den umgebenden Gitteratomen, und dies wiederum zu einer langwellige Verschiebung. Die Emission verschiebt sich hier konkret um etwa 20 nm von 523 nm auf 543 nm, d.h. der neuartige Leuchtstoff kann leicht an entsprechende Applikationen angepasst werden.

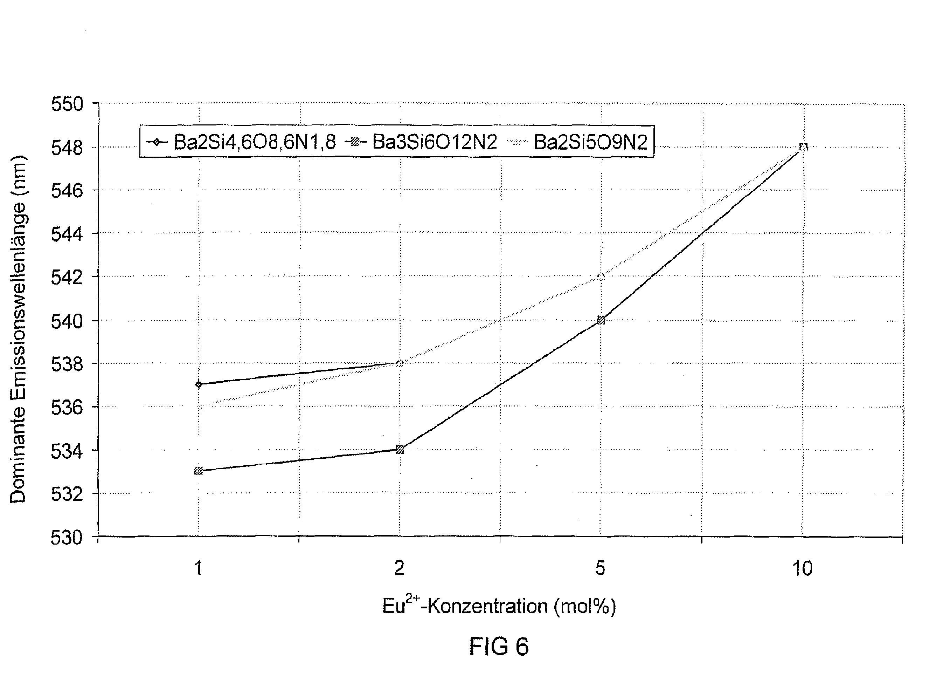

Figur 6 zeigt die Emissionswellenlänge bei drei verschiedenen Ansatzstöchiometrien. Bei Ansatzstöchiometrien nahe der durch chemische Analyse bestimmten Phase, etwa Ba2Si5O9N2, stellt sich jeweils eine sehr ähnliche dominante Emissionswellenlänge des mit Eu dotierten Leuchtstoffs ein.

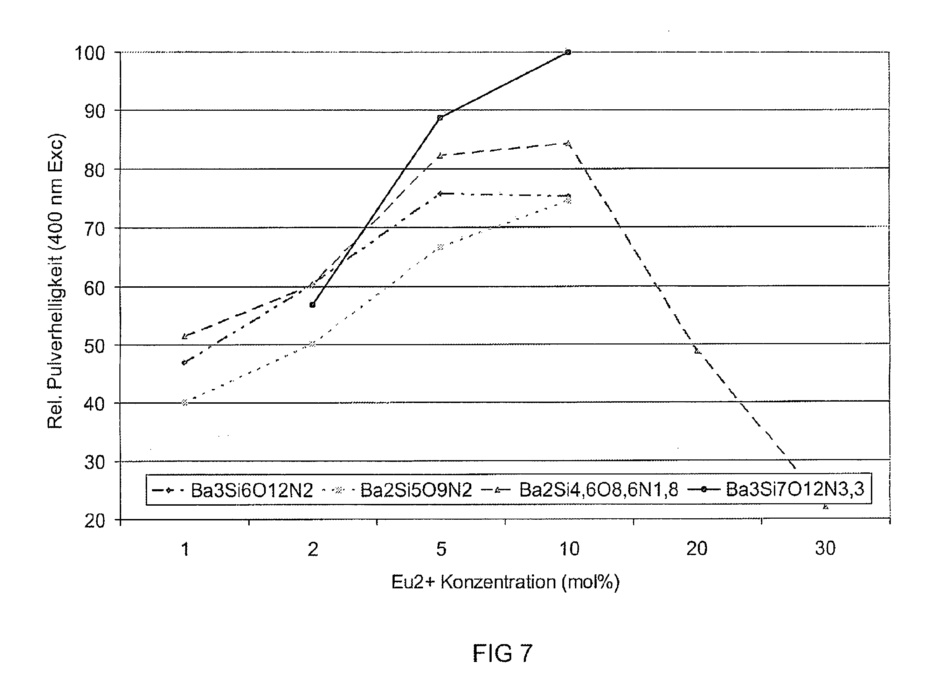

Figur 7 zeigt die relative Pulverhelligkeit als Funktion der Aktivatorkonzentration bei einer Anregungswellenlänge von 400 nm. Die bevorzugte Eu-Konzentration liegt zwischen 5 und 15% Eu.

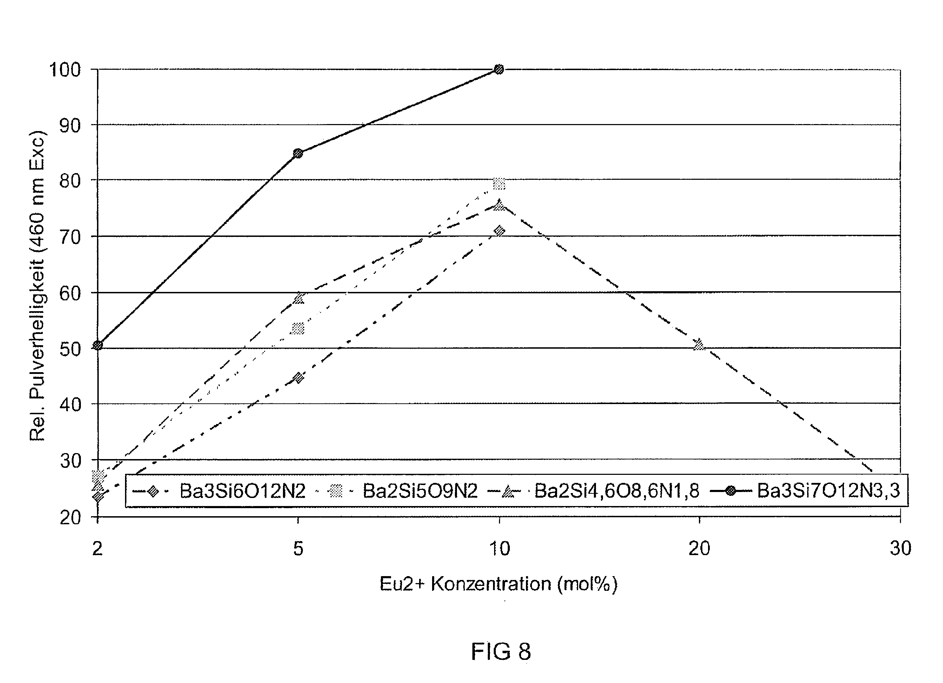

Figur 8 zeigt die relative Pulverhelligkeit als Funktion der Aktivatorkonzentration bei der Anregungswellenlänge 460 nm. Die bevorzugte Eu-Konzentration liegt zwischen 5 und 15 Mol.-% Eu. Diese Pulverhelligkeit ist ein Maß für das Verhältnis zwischen der Zahl der abgestrahlten und der eingestrahlten Photonen.

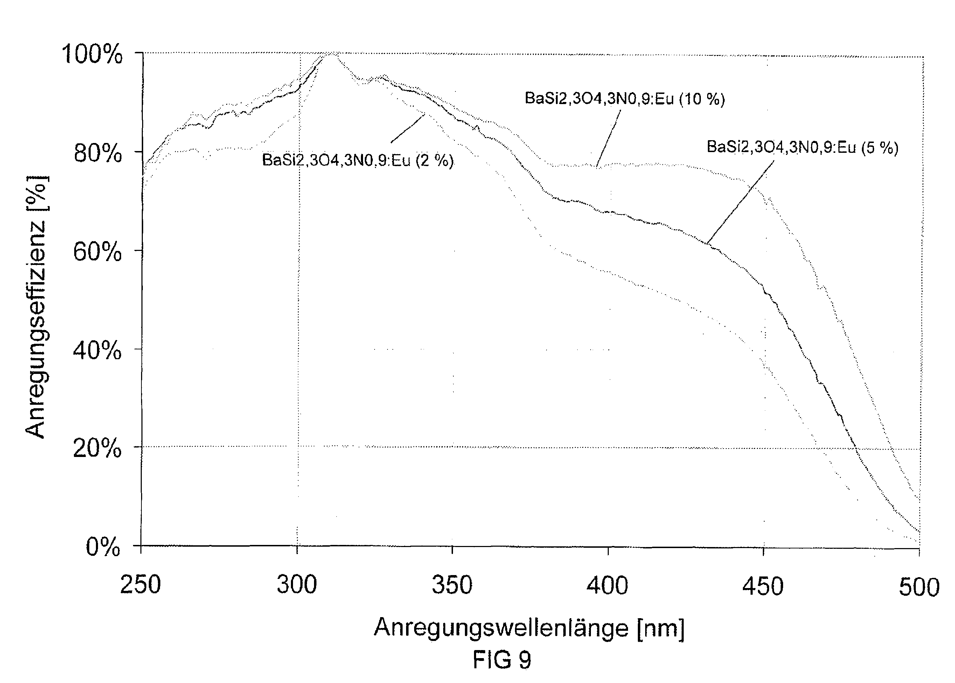

Figur 9 zeigt die Anregbarkeit des neuen Ba-SiONs (hier Ansatzstöchiometrie Ba2-xEuxSi4.6O8.6N1.8) für verschiedene Eu-Konzentrationen. Der Leuchtstoff ist in einem weiten Spektralbereich von etwa 250 bis 470 nm gut anregbar.

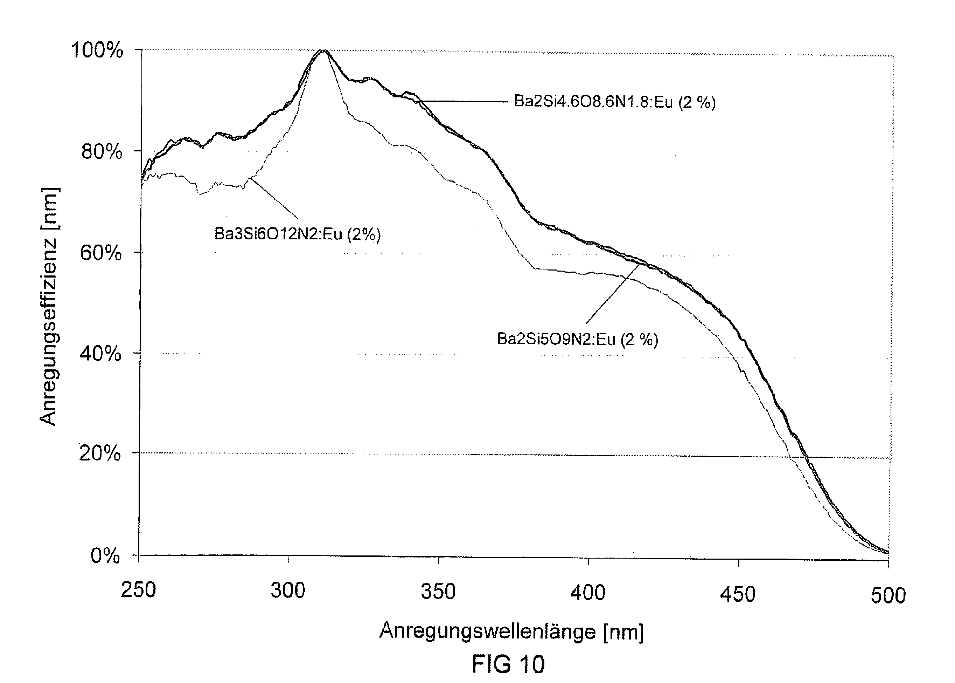

Figur 10 zeigt die Anregbarkeit des neuen Ba-SiONs (hier: drei verschiedene Ansatzmischungen). Relativ unabhängig von der exakten Ansatzstöchiometrie ergibt sich jeweils ein ähnliches Anregungsspektrum für die angegebenen Ansatzstöchiometrien. Bei der Probe Ba3Si6012N2 , die 2 % Eu-Anteil aufweist, führt ein geringer Fremdphasenanteil zu einer leichten Deformation des Spektrums.

Die erfindungsgemäßen Leuchtstoffe können auch in Zusammenhang mit anderen UV- oder Blau-Lichtquellen wie Molekularstrahlern (z.B. In-Entladungslampe), blauen OLEDs oder in Kombination mit blauen EL-Leuchtstoffen eingesetzt werden.

Sie ermöglichen die Herstellung von farbstabilen, effizienten LEDs bzw. LED-Modulen auf Basis einer Konversions-LED. Weitere Anwendungsbereiche sind LEDs mit guter Farbwiedergabe, Color-on-demand-LEDs oder weiße OLEDs. Weiter lässt sich der neue Leuchtstoff bei konventionellen Lampen, insbesondere Leuchtstofflampen, aber auch für elektrische Geräte wie CRT, PDP, FED etc. anwenden.

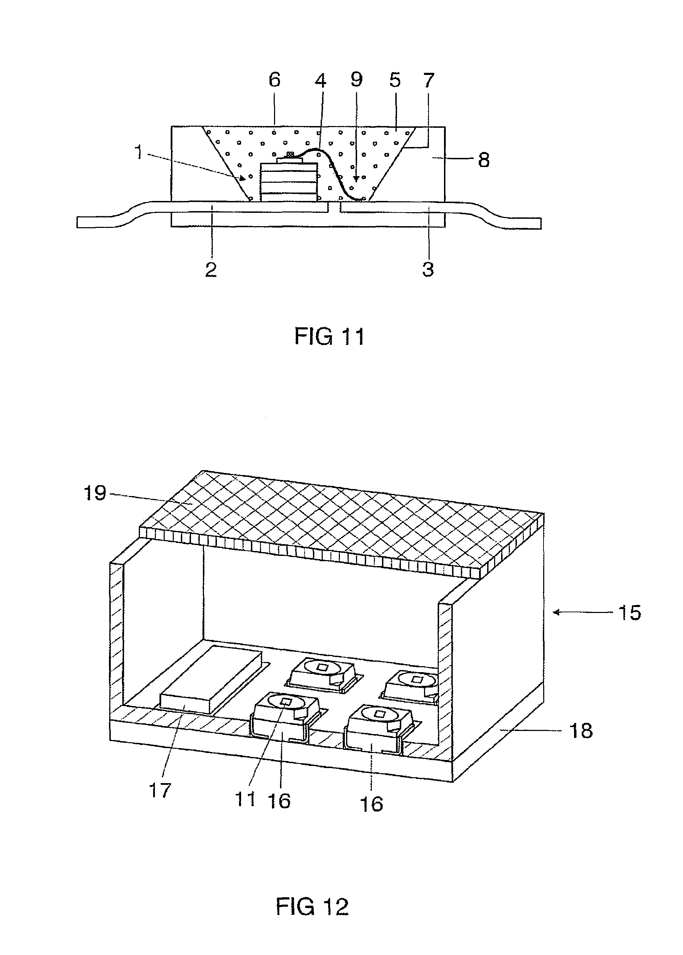

Der Aufbau einer Lichtquelle für grünes Licht ist in Figur 11 explizit gezeigt. Die Lichtquelle ist ein Halbleiterbauelement mit einem Chip 1 des Typs InGaN mit einer Peakemissionswellenlänge im UV von beispielsweise 405 nm, das in ein lichtundurchlässiges Grundgehäuse 8 im Bereich einer Ausnehmung 9 eingebettet ist. Der Chip 1 ist über einen Bonddraht 4 mit einem ersten Anschluss 3 und direkt mit einem zweiten elektrischen Anschluss 2 verbunden. Die Ausnehmung 9 ist mit einer Vergussmasse 5 gefüllt, die als Hauptbestandteile ein Silikonharz (80 bis 90 Gew.-%) und Leuchtstoffpigmente 6 (typisch weniger als 20 Gew.-%) enthält. Die Ausnehmung hat eine Wand 7, die als Reflektor für die Primär- und Sekundärstrahlung vom Chip 1 bzw. den Pigmenten 6 dient. Die Primärstrahlung der UV-LED wird vollständig vom Leuchtstoff in grün konvertiert. Der verwendete Leuchtstoff ist das oben beschriebene Ba-Sion Ba2Si509N2:Eu.

Analog lässt sich damit auch eine Lichtquelle für weißes Licht realisieren, indem drei Leuchtstoffe verwendet werden, die von der UV-Strahlungsquelle angeregt werden, rot, grün und blau zu emittieren. Der grüne Leuchtstoff ist das neuartige Ba-Sion Ba2Si5O9N2:Eu, der rote ist beispielsweise Ca5Al4Si8N18:Eu oder ein Nitridosilikat (Ca,Sr)2Si5N8:Eu und der blaue ist beispielsweise ein Aluminat- oder Phosphat-Leuchtstoff wie BAM:Eu oder SCAP:Eu o.ä.

Der Aufbau einer anderen Lichtquelle für weißes Licht ist in Figur 12 explizit gezeigt. Die Lichtquelle, ist ein Halbleiterbauelement 16 vom Typ LED mit einem blau emittierenden Chip 11 des Typs InGaN mit einer Peakemissionswellenlänge von beispielsweise 460 nm. Das Halbleiterbauelement 16 ist in ein lichtundurchlässiges Grundgehäuse 18 mit Seitenwand 15 und Deckel 19 eingebettet. Der Chip ist die Primärlichtquelle für zwei Leuchtstoffe. Der erste Leuchtstoff 14 ist das Oxinitridosilikat Ba2Si5O9N2:Eu(10%), der die primäre Strahlung des Chips 13 teilweise konvertiert und in grüne Strahlung der Peakemission 530 nm umwandelt. Der zweite Leuchtstoff ist das neuartige Nitridosilikat (Ca,Sr,Mg)5Al4Si8N18:Eu, das die primäre Strahlung des Chips 13 teilweise konvertiert und in rote Strahlung der Peakemission 630-660 nm umwandelt.

Der besondere Vorteil der Verwendung einer langwelligen primären Lichtquelle (450 bis 465 nm) für die Lumineszenzkonversions-LED ist, dass hier Probleme mit Alterung und Degradation von Gehäuse und Harz bzw. Leuchtstoff vermieden werden, so dass eine lange Lebensdauer erzielt wird.

In einem anderen Ausführungsbeispiel wird als primäre Lichtquelle eine UV-LED (etwa 380 nm) für eine weiße RGB Lumineszenzkonversions-LED verwendet, wobei hier Probleme mit Alterung und Degradation von Gehäuse und Harz bzw. Leuchtstoff durch zusätzliche an sich bekannte Maßnahmen möglichst weitgehend vermieden werden müssen wie sorgfältige Wahl des Gehäusematerials, Zugabe UV-resistenter Harzkomponenten. Der große Vorteil dieser Lösung ist die geringe Blickwinkelabhängigkeit der Emissionsfarbe und die hohe Farbstabilität.

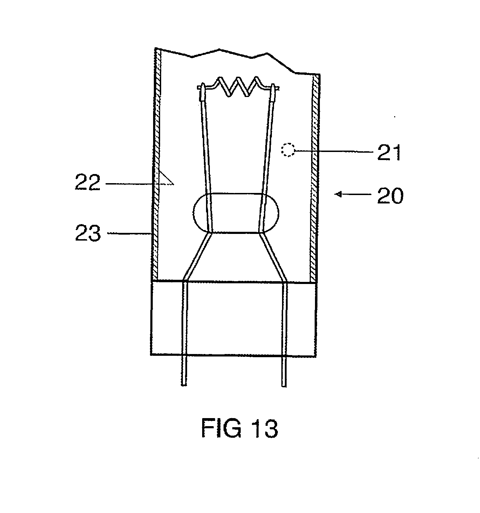

Figur 13 zeigt eine Niederdruck-Entladungslampe 20 mit einer quecksilberfreien Gasfüllung 21 (schematisiert), die eine Indiumverbindung und ein Puffergas analog WO 02/10374 enthält, wobei eine Schicht 22 aus Ba-Sion. In aller Regel werden bei Leuchtstofflampen sog. Dreibandenleuchtstoffe eingesetzt. Dazu ist ein blauer und roter Leuchtstoff beigemengt. Gut geeignet sind BAM:Eu oder BaMgA110O17:Eu sowie rotes Nitridosilikat (Ba,Sr,Ca)2Si5N8:Eu.

Dieses Leuchtstoff-System ist einerseits der Indium-Strahlung angepasst, weil diese wesentliche Anteile sowohl im UV als auch im blauen Spektralbereich hat, die beide gleichermaßen gut absorbiert werden. Diese Mischung eignet sich aber auch für konventionelle Leuchtstofflampen. Möglich ist auch die Anwendung bei einer Indium-Lampe auf Hochdruck-Basis wie an sich aus US 4 810 938 bekannt. Grünverbesserung ist möglich. Dabei hat die Lampe ein übliches Entladungsgefäß mit Metallhalogenid-Füllung. Die Strahlung trifft auf eine Leuchtstoff-Schicht auf einem Außenkolben, die einen Teil der primären Strahlung in grüne Strahlungsanteile umwandelt. Die Leuchtstoff-Schicht besteht aus Ba-Sion:Eu. Diese Technik ist im Prinzip beispielsweise in der US-B 6 958 575 beschrieben.

Weitere Informationen sind in der nächsten Tab. 4a und 4b enthalten. Tab. 4a bezieht sich auf eine Anregung mit einer Wellenlänge von 400 nm. Tab. 4b bezieht sich auf eine Anregung mit einer Wellenlänge von 460 nm. Beide Tabellen zeigen für verschiedene Ausführungsbeispiele die Einwaagenstöchiometrie, die Konzentration des Aktivators, die Farbortkomponenten x und y, die dominante Wellenlänge, die relative Quanteneffizienz Q.E. und die relative Helligkeit in Prozent.

Weiteres Ausführungsbeispiel ist ein LED-Modul, bestehend aus mindestens einem Satz von drei rot, grün und blau emittierenden LEDs. Diese RGB-Modul wird für die Anregung von LCD-Bildschirmen oder RPTV-Geräten verwendet. Die grüne LED ist eine primär UV-emittierende pc-LED (Phosphor-conversion-LED), die mittels eines neuartigen grünen Ba-Sions in grüne Strahlung umgewandelt wird. Die Peakwellenlänge der UV-LED ist insbesondere 400 nm. Die Temperatur im Betrieb des Moduls steigt leicht auf 200 °C, was der temperaturstabile Leuchtstoff problemlos bewältigt.

Grundsätzlich ist es auch möglich, Si zumindest teilweise durch Ge zu ersetzen, bevorzugt bis zu 20 Mol.-%. Aber auch ein vollständiger Ersatz ist möglich.

Anstatt Ba und/oder Sr allein kann auch zusätzlich Ca und/oder Mg und/oder Zn und/oder Cu Bestandteil des Kations M sein. Bevorzugt ist der Anteil nicht höher als 30 Mol.-% des Kations M.

Anstatt allein mit Eu und/oder Ce kann der neuartige Leuchtstoff auch mit Mn oder Yb zusätzlich kodotiert sein. Gute Ergebnisse liefert insbesondere die Kodotierung Eu, Yb. Außerdem kann auch Tb3+ als Aktivator verwendet werden, allein oder in Kombination mit den anderen. Während die Dotierung mit Ce zu einem UV- bis blauemittierenden Leuchtstoff bei UV-Anregung, insbesondere bei der bekannten Hg-Linie 254 nm, führt, emittiert die reine Tb-Variante bei derselben UV-Anregung grün.

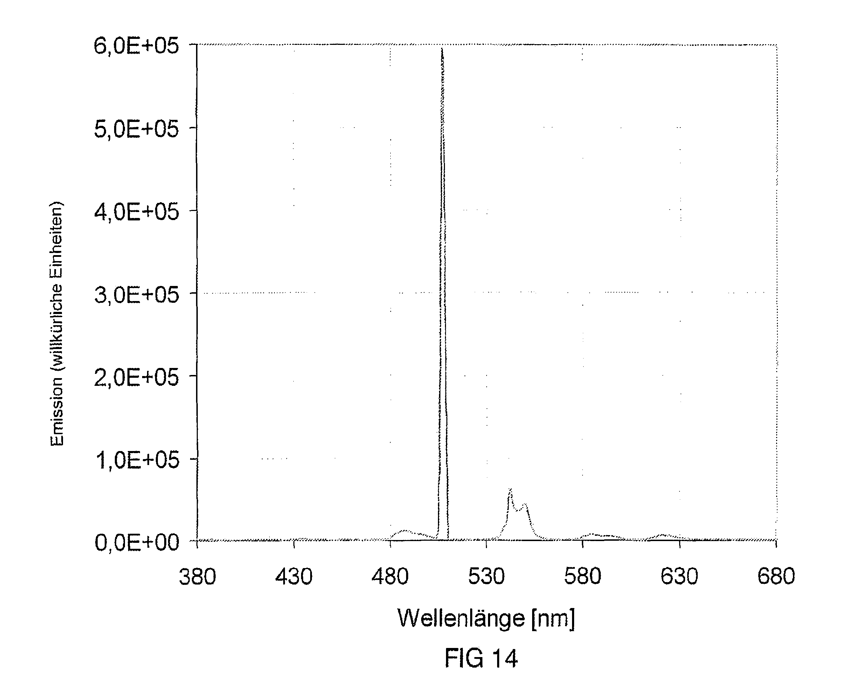

Figur 14 zeigt das Emissionsspektrum einer Tb3+-dotierten Probe des Leuchtstoffs (Ba_{0,95}Tb_{0,05})₂Si₅O₉N₂ bei einer Anregung im tiefen UV bei 254 nm. Diese Tb3+-dotierte Probe zeigt eine typische Linienemission, wie dies bei Tb3+-Emission häufig zu beobachten ist. Dieser Leuchtstoff kann außerdem mit Ce sensibilisiert werden, gemäß der Formel Ba₂Si₅O₉N₂: (Tb,Ce) . Bei diesem Leuchtstoff ist die Anregbarkeit tendenziell langwelliger und ähnelt mehr dem der reinen Ce-dotierten Probe.

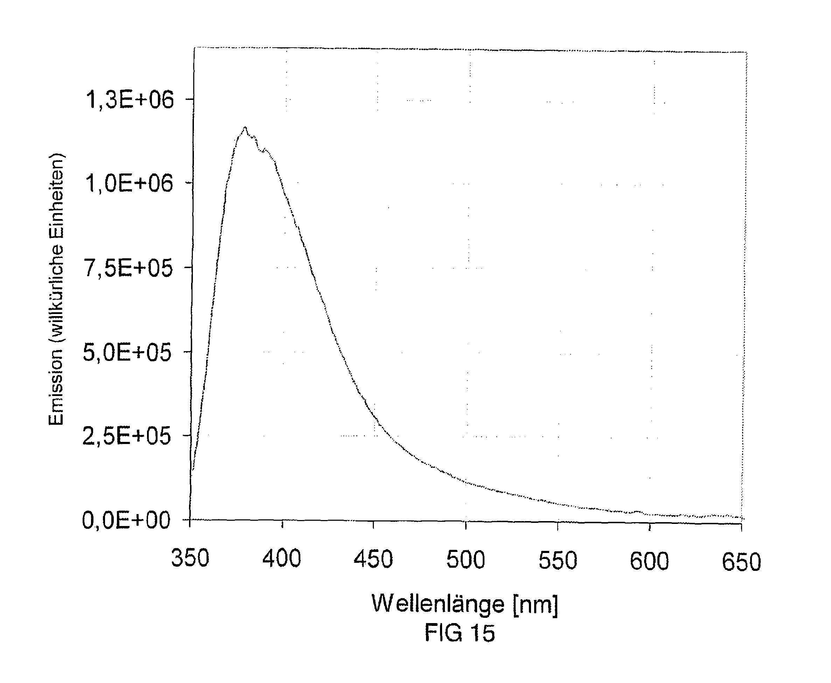

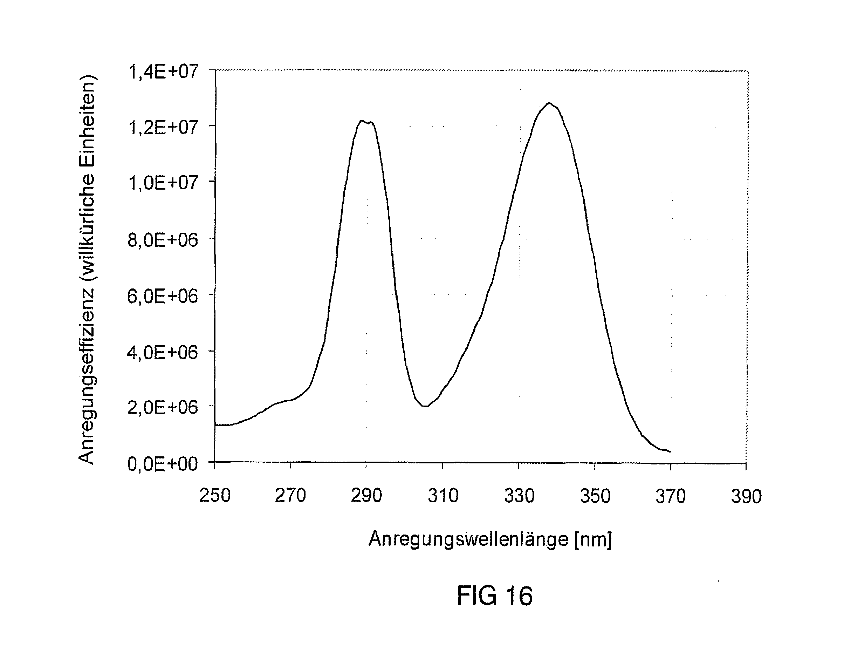

Figur 15 zeigt das Emissionsspektrum der Ce-dotierten Probe (Ba_{0,98}Ce_{0,02})₂Si₅O₉N₂ für eine Anregung bei 338 nm. Dieses Ausführungsbeispiel leuchtet blau-violett. Figur 16 zeigt das Anregungsspektrum der gleichen Probe, wobei die Emission bei 378 nm beobachtet wurde.

In Tab. 5 sind verschieden dotierte Leuchtstoffe des Typs Ba2Si509N2:D mit den Dotierungen D=Eu, bzw. D=Ce bzw. D=Tb sowie D=(Eu,Mn) und D=(Eu,Ce) gegenübergestellt. Es ist jeweils die Farbortkomponente x und y angegeben. Dabei dient das Eu-dotierte Ausführungsbeispiel als Referenz. Verglichen damit zeigt eine (Eu,Ce)-kodotierte Probe keine Verschiebung des Farborts, da die Ce-Bande bei Anregung im Bereich 370 bis 400 nm nicht signifikant ist.

Die Ce-dotierte Probe leuchtet blau-violett. Die Tbdotierte Probe zeigt sich als grüner Linienstrahler. Der Einbau von Mn2+ als Kodotierung zu Eu2+ ist in kleinen Mengen möglich. Ce-dotierte und Ce,Tb-kodotierte Leuchtstoffe eignen sich auch für Leuchtstofflampen oder andere UV-Lichtquellen wie Excimerstrahler, die im fernen UV anregen und beispielsweise eine Dreibandenmischung verwenden. Mittels des neuartigen Ce-dotierten und Ce,Tb-kodotierten Sion-Leuchtstoffs kann damit sogar eine Lichtquelle für nahes UV oder mit Peak-Emission bei etwa 380 bis 390 nm realisiert werden Dabei ist das Sion der einzige Leuchtstoff. Die Anregung, die im Bereich 250 bis 375 nm gut möglich ist, gelingt besonders effizient im Bereich 290 bis 340 nm.

Generell lässt sich die Effizienz insbesondere der Tb3+ und Ce3+-dotierten Ausführungsbeispiele optimieren, wenn kleine Mengen an Li+ und/oder Na+ dazu eingebaut werden, die der Ladungskompnesation dienen. Die zusätzliche positive Ladung kann generell entweder über einwertige Ionen wie Li oder Na eingebracht werden, alternativ kann außerdem eine leichte Änderung des Ba/Si-Verhältnisses oder eine leichte Änderung des O/N-Verhältnisses erfolgen.

Wesentlich ist die Eigenschaft des neuen temperaturstabilen Leuchtstoffs, daß er aus dem M-Si-O-N System stammt, mit einem Kation M, wobei M durch Ba oder Sr allein oder in Mischung repräsentiert ist oder zusätzlich mit mindestens einem weiteren Element aus der Gruppe Ca, Mg, Zn, Cu kombiniert sein kann, wobei der Leuchtstoff mit Eu oder Tb allein oder in Mischung, ggf. in Kodotierung mit Mn, aktiviert ist, wobei der Aktivator D das Kation teilweise ersetzt. Da der Leuchtstoff aus der Ansatzstöchiometrie MO-Si02-Si3N4 hergestellt ist mit einem gegenüber dem bekannten Leuchtstoff MSi2O2N2 erhöhten Sauerstoffgehalt, hat er bevorzugt im wesentlichen die Zusammensetzung aMO x bSi02 x cSi3N4. Daher folgt seine Stöchiometrie im wesentlichen der Formel MₐSi_{b+3c}O_{a+2b}N_{4c}.

Dabei müssen a,b,c keine ganzen Zahlen sein. Der Leuchtstoff zeichnet sich dabei dadurch aus, daß das Verhältnis O:M >1 ist und daß das Verhältnis O:Si > 2 ist.

Besonders gute Ergebnisse zeigt ein Leuchtstoff, bei dem die Relationen zwischen a, b und c so gehalten sind, daß gilt: b:c= 4,8 bis 8,0 und/oder a:c = 3,5 bis 5,5. Bevorzugt liegt b:c im Bereich 5 bis 6 und/oder a:c im Bereich 3,5 bis 4.

Ein in dieser Hinsicht besonders herausragender Leuchtstoff hat die Ansatzstöchiometrie Ba₉Si₂₁O₃₆N₁₀ oder anders dargestellt Ba₃Si₇O₁₂N_{3,3}. Dieser Leuchtstoff lässt sich mit dem oben angegebenen Herstellverfahren mit besonders hoher Phasenreinheit herstellen und zeigt eine hervorstechende Effizienz.

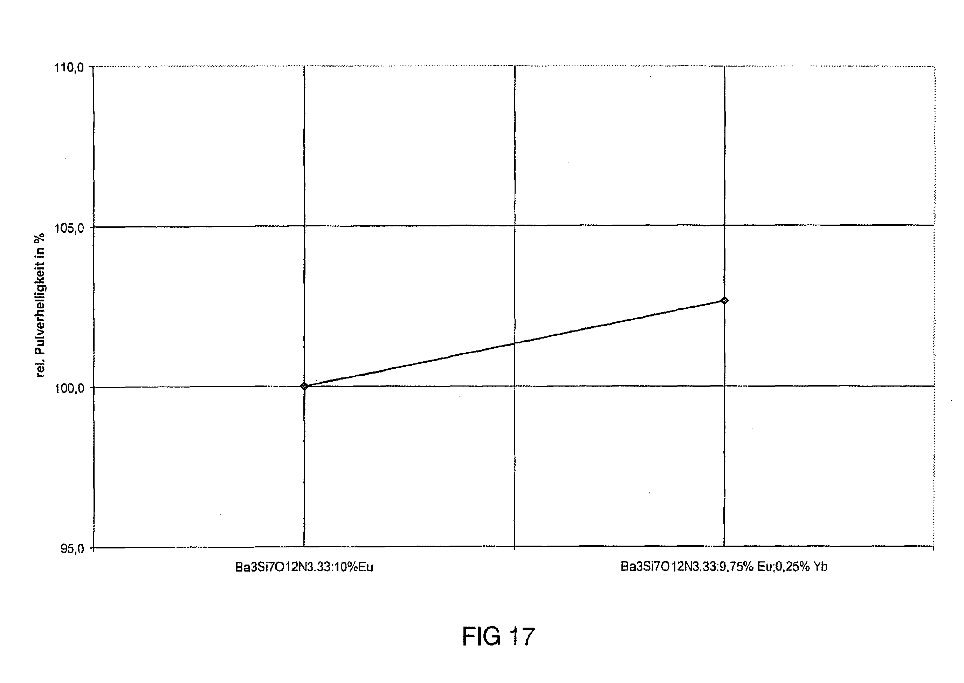

Figur 17 zeigt einen Vergleich der Pulverhelligkeit eines Leuchtstoffs mit der Ansatzstöchiometrie Ba3Si7012N3,33:D wobei eine Probe mit D=10%Eu, bezogen auf den Anteil des Ba, verglichen wurde mit einer gleichartigen Probe, jedoch mit dem Unterschied, dass hier D= 9,75%Eu + 0,25 % Yb gewählt wurde. Figur 17 zeigt, dass die Beigabe von Yb zu einer um etwa 3% höheren Pulverhelligkeit führt, verglichen mit der reinen Eu-Dotierung.

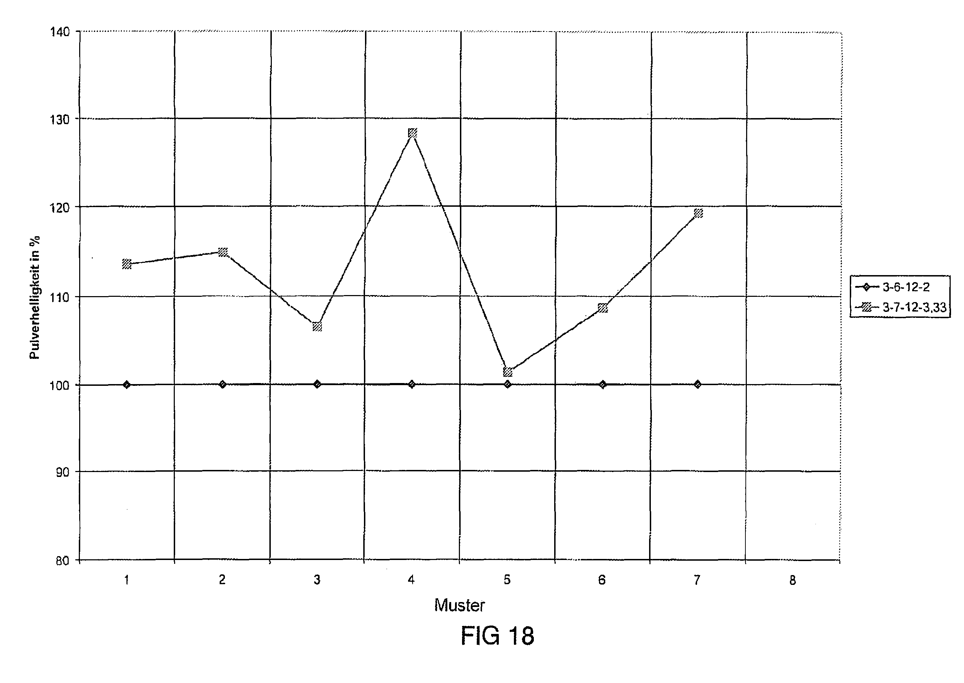

Figur 18 zeigt einen Vergleich der Pulverhelligkeit eines Eu-dotierten Leuchtstofftyps mit der Ansatzstöchiometrie Ba3Si7012N3,33 gegenüber der Pulverhelligkeit des Leuchtstofftyps mit der Ansatzstöchiometrie Ba3Si6012N2. Dabei wurden die Herstellbedingungen gleichartig variiert, was zu den Mustern 1 bis 7 führte. Unabhängig von den Herstellbedingungen ist die Pulverhelligkeit des Leuchtstoffs mit der Ansatzstöchiometrie Ba3Si7O12N3,33 immer höher, und zwar zwischen etwa 2 und 28% höher als die eines Leuchtstoffs, der auf einer Einwaage gemäß der Ansatzstöchiometrie Ba3Si6012N2 basiert. Eine röntgenografische Strukturanalyse dieser Proben mit der Ansatzstöchiometrie Ba3Si7O12N3,33 führte zu dem Ergebnis, dass diese Proben die geringste Linienbreite (geringste mittlere Mikroverzerrung) aller untersuchten Proben aufweisen. Die Indizierung ergibt eine trigonale bzw. hexagonale Raumgruppe mit a = 7,5094(1) 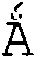 und c = 6,4753(1) 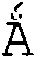 mit Zellvolumen V = 316,23 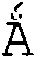 ³. Eine widerspruchsfreie Beschreibung der Bariumlagen unter Berücksichtigung der Volumeninkremente möglicher Zusammensetzung führen auf die Raumgruppe P3 bzw P-3. Der Leuchtstoff zeigt aus der röntgenografischen Charakerisierung unter Berücksichtigung der Elektroneutralität eine ideale Zusammensetzung Ba_{2,5}Si₆O_{11,5}N₂. Versucht man dagegen einen Leuchtstoff mit der Zusammensetzung Ba3Si6O12N2 dadurch herzustellen, dass als Ansatzstöchiometrie Ba3Si6O12N2 gewählt wird, so ergibt sich als Endprodukt im wesentlichen eine Phase mit kleineren Gitterkonstanten a und c sowie ein signifikanter Anteil der Fremdphase BaSi2O5, siehe auch Tab. 3. Allgemein zeigen Leuchtstoffe des Typs mit der Stöchiometrie M_{2,5}Si₆O_{11,5}N₂, wobei insbesondere M = Ba allein oder überwiegend mit mehr als 50 Mol.-% ist, herausragende Eigenschaften. Insbesondere ist dabei die Dotierung Eu oder (Eu,Yb) oder Ce.

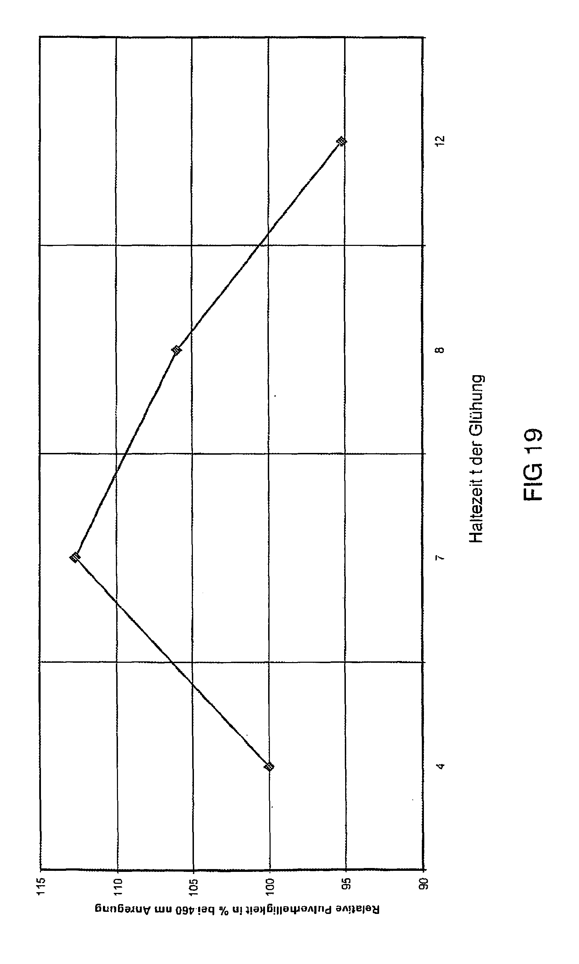

Figur 19 zeigt die Pulverhelligkeit als Funktion der Haltezeit bei hoher Temperatur. Die Haltezeit bei der Glühung ist in Std. angegeben. Die Temperatur von 1300 °C bei der Glühung zeigt eine optimale Haltezeit im Bereich von etwa 5 bis 8 Std. Gute Ergebnisse werden in einem Zeitraum zwischen 4 und 10 Std. erzielt.

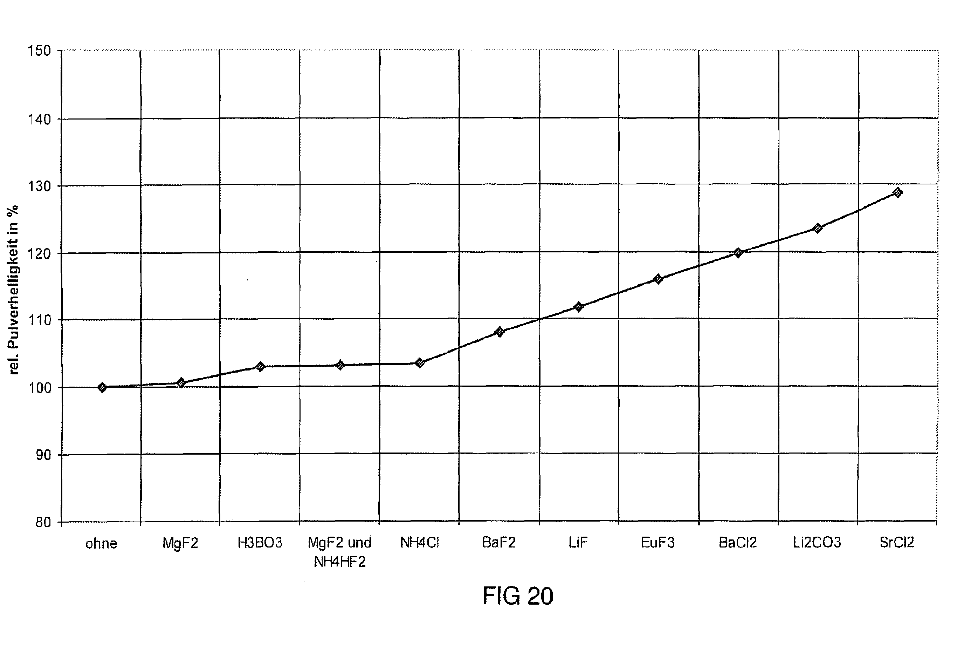

Figur 20 zeigt den Einfluss des Schmelzmittels auf die Pulverhelligkeit. Mit Schmelzmitteln wird eine Steigerung der Pulverhelligkeit erzielt, die je nach Schmelzmittel bei etwa 2 bis 30 % liegt. Besonders geeignet sind Chloride, vor allem des Ba und Sr, und Karbonate, vor allem des Li. In der Ansatzstöchiometrie sind bevorzugte Anteile des Schmelzmittels zwischen 0,01 bis 5 Gew.-%, besonders geeignet ist der Wertebereich zwischen 0,1 und 3 Gew.-%.

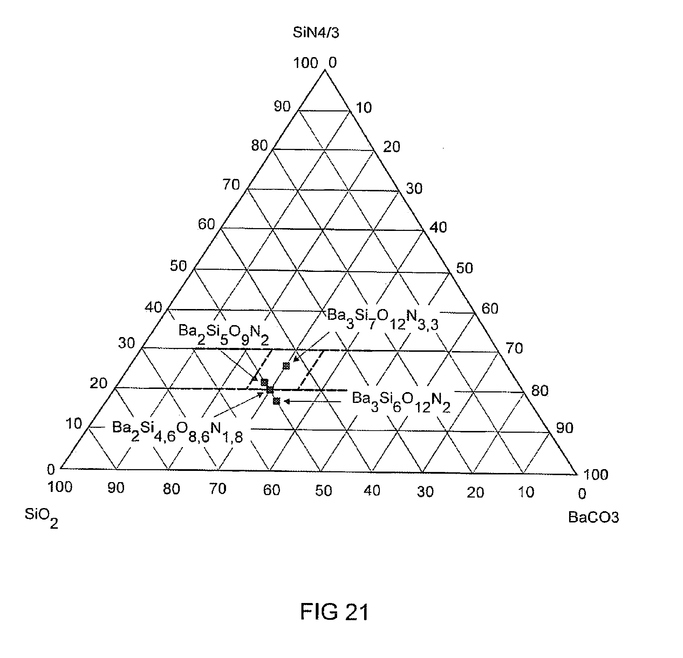

Figur 21 zeigt ein Phasendiagramm ähnlich wie in Figur 3 dargestellt. Dabei sind die besonders hohe Effizienz und Phasenreinheit zeigenden Ansatzstöchiometrien Ba2Si4,6O8,6N1,8 und Ba2Si5O9N2 und Ba3Si7O12N3,3 dargestellt. Sie liegen alle in einem Band, in dem der SiN4/3-Anteil zwischen 20 und 30 % liegt. Bevorzugt liegt die Ansatzstöchiometrie im eingezeichneten Viereck, das noch die Grenzlinien eines Si02-Anteils von 65 bis 75% hat. Dagegen liegt das Muster Ba3Si6O12N2 bei etwa 17% SiN4/3-Anteil und hat deutlich schlechtere Phasenreinheit und Effizienz. Für die Stöchiometrie des Ansatzes Ba3Si7O12N3,3 gilt, dass das Verhältnis BaC03:Si02 bei etwa 1:1,5 liegt. Der Anteil des SiN4/3 liegt bei etwa 25%. Die Unschärfe bezieht sich auf den Dotiergehalt an Eu, das meist über Eu2O3 eingebracht wird. Eine massenspektroskopische Untersuchung der geglühten Ansatzstöchiometrie Ba3Si7O12N3,3 (N : O = 1 : 3,6) bestätigte den erhöhten Stickstoffanteil gegenüber der Ba3Si6O12N2-Stöchiometrie (N : O = 1 : 6). Die Verbindungen aus Figur 21 verstehen sich als Leuchtstoff mit 2% Eu für Ba, also beispielsweise M = (Ba0,98Eu0,02) als Kation M in M3Si7O12N3,3.

In Tab. 6a sind Kennwerte der Struktur für verschiedene Leuchtstoffe unterschiedlicher Ansatzstöchiometrie dargestellt, die überwiegend im Bereich 20 bis 30 % SiN4/3-Anteil liegen. Der Dotiergehalt ist 2 Mol.-% Eu. Angegeben sind die Gitterkonstanten a und c sowie der Fremdphasenanteil.

Tab. 6b zeigt für verschiedene Ausführungsbeispiele die Einwaagenstöchiometrie, die Effizienzen, die Farbortkomponenten x und y, die dominante Wellenlänge und die relative Quanteneffizienz Q.E. in Prozent und zwar für 400 nm Anregungswellenlänge. Der Dotiergehalt ist 2 Mol.-% Eu.

**Tab. 6a**

| *Probe* | *a (in* 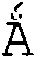 *)* | *c (in* 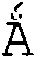 *)* | *Ansatzstöchiometrie* | *Anteil (%) Fremdphase* |
|---|---|---|---|---|
| *BP 376*/*07* | *7,514* | *6,479* | *Ba3Si7O11N4* | *21%BaSi2O2N2* <*3% BaSi2O5* |
| *BP 377*/*07* | *7,510* | *6,478* | *Ba3Si7O13N2,67* | - |
| *BP 378*/*07* | *7,509* | *6,480* | *Ba3Si7O14N2* | *29% BaSi2O5* |
| *BP 379*/*07* | *7,510* | *6,476* | *Ba3Si7O12N3,33* | - |
| *BP 380*/*07* | *7,513* | *6,482* | *Ba2,5Si7,5O12,5N3,33* | *-* |
| *BP 381*/*07* | *7,513* | *6,478* | *Ba2,5Si7,5O13,5N2,67* | <*3% BaSi2O5* |
| *BP 382*/*07* | *7,512* | *6,481* | *Ba2,5Si7,5O11,5N4* | - |

**Tab. 6b**

| *Probe BP---l07* | *Ansatzstöchiometrie* | *x* | *y* | λ*_{Dom} (nm)* | *rel. Q. E. (*%*)* |
|---|---|---|---|---|---|
| *174* | *Ba3Si6O12N2* | *0,258* | *0,591* | *537* | *95* |
| *376* | *Ba3Si7O11N4* | *0,250* | *0,616* | *536* | *58* |
| *377* | *Ba3Si7O13N2,67* | *0,252* | *0,630* | *538* | *98* |
| *378* | *Ba3Si7O14N2* | - | - | *-* | - |
| *379* | *Ba3Si7O12N3,33* | *0,252* | *0,626* | *538* | *100* |
| *380* | *Ba2,5Si7,5O12,5N3,33* | *0,252* | *0,625* | *538* | *75* |
| *381* | *Ba2,5Si7,5O13,5N2,67* | - | - | - | - |
| *382* | *Ba2, 5Si7, 5O11, 5N4* | *0,250* | *0,623* | *537* | *78* |

**Tab. 3**

| Probe BP---/07 | Einwaagestöchiometrie | | | | | | | | Phasenzusammensetzung nach XRD | x | y | λ_{Dom} (nm) | rel Q E. (%) |
|---|---|---|---|---|---|---|---|---|---|---|---|---|---|
| 121 | Ba | ₄ | Si | ₅ | O | ₈ | N | ₂ | - | 0,259 | 0,623 | 539 | 61 |
| 122 | Ba | ₁ | Si | ₅ | O | _{4,4} | N | _{4,4} | - | 0,248 | 0,607 | 535 | 55 |
| 123 | Ba | _{1,3} | Si | ₁ | O | ₃ | N | _{0,2} | - | 0,167 | 0, 555 | 510 | 84 |
| 124 | Ba | _{1,3} | Si | _{1,45} | 0 | _{3,2} | N | _{0,66} | - | 0,271 | 0,511 | 532 | 6 |
| 126 | Ba | ₁ | Si | ₉ | O | ₃ | N | _{10,7} | Neue Phase, Si₃N₄ | - | - | - | - |
| 127 | Ba | ₁ | Si | ₉ | O | ₅ | N | _{9,3} | Neue Phase, Si₃N₄ | 0,244 | 0,586 | 532 | 33 |
| 128 | Ba | ₁ | Si | ₄ | O | ₂ | N | _{4,65} | Ba₂SiO₄, Si₃N₄ | 0,170 | 0,517 | 507 | 31 |
| 129 | Ba | ₁ | Si | ₉ | O | ₇ | N | ₈ | Neue Phase, Si₃N₄ | 0,241 | 0,595 | 532 | 25 |
| 130 | Ba | ₁ | Si | ₄ | O | ₃ | N | ₄ | Neue Phase, Si₃N₄ | - | - | - | - |
| 131 | Ba | ₁ | Si | _{2,3} | 0 | _{1,67} | N | _{2,67} | Ba₂SiO₄, Si₃N₄ | - | - | - | - |
| 132 | Ba | ₁ | Si | ₉ | O | ₉ | N | _{6,7} | Neue Phase, Si₃N₄ | 0,245 | 0,599 | 534 | 30 |
| 133 | Ba | ₁ | Si | ₄ | O | ₄ | N | _{3,35} | Neue Phase | 0,253 | 0,612 | 537 | 66 |
| 134 | Ba | ₁ | Si | _{2,3} | O | _{2,3} | N | _{2,22} | ? | 0,182 | 0,505 | 507 | 16 |
| 135 | Ba | ₁ | Si | _{1,5} | O | _{1,5} | N | _{1,68} | Ba₂SiO₄, Si₃N₄ | - | - | - | - |
| 136 | Ba | ₁ | Si | ₉ | O | ₁₁ | N | _{5.3} | Neue Phase, Si₃N₄, SiO₂ | 0,247 | 0,602 | 534 | 33 |
| 137 | Ba | ₁ | Si | ₄ | O | ₅ | N | _{2,65} | Neue Phase | 0,250 | 0,613 | 536 | 70 |
| 138 | Ba | ₁ | Si | _{2,3} | O | ₃ | N | _{1,77} | ?, BaSiO₃ | - | - | - | - |
| 139 | Ba | ₂ | Si | ₃ | O | ₄ | N | _{2,65} | Ba₂SiO₄ | - | - | - | - |
| 140 | Ba | ₁ | Si | ₁ | O | _{1,4} | N | _{1,06} | Ba₂SiO₄ | - | - | - | - |
| 141 | Ba | ₁ | Si | ₉ | O | ₁₃ | N | ₄ | ?, SiO₂ | 0,254 | 0,590 | 535 | 30 |
| 142 | Ba | ₁ | Si | ₄ | O | ₆ | N | ₂ | Neue Phase, BaSi₂O₅ | 0,256 | 0,618 | 538 | 55 |
| 143 | Ba | ₁ | Si | _{2,3} | O | _{3,67} | N | _{1,33} | Neue Phase, ? | 0,252 | 0,621 | 537 | 50 |
| 144 | Ba | ₂ | Si | ₃ | O | ₅ | N | ₂ | ?, BaSiO₃ | - | - | - | - |
| 145 | Ba | ₅ | Si | ₅ | O | ₉ | N | ₄ | Ba₂SiO₄ | - | - | - | - |
| 146 | Ba | ₁ | Si | _{0.67} | O | _{1,3} | N | _{0,67} | Ba₂SiO₄ | 0,174 | 0,545 | 510 | 63 |
| 147 | Ba | ₁ | Si | ₉ | O | ₁₅ | N | _{2.67} | Neue Phase, SiO₂ | 0,255 | 0,602 | 537 | 58 |
| 148 | Ba | ₂ | Si | ₈ | O | ₁₄ | N | _{2.67} | ? | 0,264 | 0,623 | 540 | 67 |
| 149 | Ba | ₁ | Si | _{2.3} | O | _{4,3} | N | _{0,9} | Neue Phase | 0,255 | 0,622 | 538 | 100 |
| 150 | Ba | ₁ | Si | _{1,5} | O | ₃ | N | _{0,668} | BaSiO₃ | - | - | - | - |
| 151 | Ba | ₁ | Si | ₁ | O | _{2.2} | N | _{0.534} | Ba₂SiO₄, SiO₂ | 0,167 | 0,545 | 510 | 70 |
| 152 | Ba | ₁ | Si | _{0,67} | O | _{1.67} | N | _{0,445} | Ba₂SiO₄ | - | - | - | - |
| 153 | Ba | ₁ | Si | _{0.43} | O | _{1.3} | N | _{0.38} | Ba₂SiO₄ | - | - | - | - |
| 154 | Ba | ₁ | Si | ₉ | O | ₁₇ | N | _{1.3} | SiO₂, BaSi₂O₅ | 0,274 | 0,586 | 541 | 39 |
| 155 | Ba | ₁ | Si | ₄ | O | ₈ | N | _{0.65} | SiO₂, BaSi₂O₅ | - | - | - | - |
| 156 | Ba | ₁ | Si | _{2.3} | O | ₅ | N | _{0.43} | BaO(?), BaSi₂O₅ | 0,262 | 0,616 | 540 | 92 |
| 157 | Ba | ₂ | Si | ₃ | O | ₇ | N | _{0,65} | Neue Phase, BaSi₂O₅ | 0,282 | 0,567 | 542 | 42 |
| 158 | Ba | ₁ | Si | ₁ | O | _{2,6} | N | _{0,26} | Ba₂SiO₄, SiO₂ | 0,180 | 0,551 | 512 | 25 |
| 159 | Ba | ₁ | Si | _{0.67} | O | _{2.8} | N | _{0.216} | Ba₂SiO₄ | 0,163 | 0,547 | 509 | 108 |
| 160 | Ba | ₁ | Si | _{0,43} | O | _{1.57} | N | _{0,19} | Ba₂SiO₄, Ba₃SiO₅ | 0,410 | 0,501 | 569 | 86 |
| 161 | Ba | ₁ | Si | _{0.25} | O | _{1.25} | N | _{0.163} | Ba₃SiO₅ | 0,517 | 0,465 | 582 | 94 |
| 168 | Ba | ₃ | Si | ₇ | O | ₁₄ | N | ₂ | Neue Phase, BaSi₂O₅ | 0,260 | 0,621 | 539 | 95 |
| 169 | Ba | _{0.7} | Si | _{1,3} | O | _{2.7} | N | _{0,4} | Neue Phase, SiO₂ | 0,260 | 0,585 | 537 | 77 |
| 170 | Ba | _{0.7} | Si | _{1.3} | O | _{2.5} | N | _{0,524} | Neue Phase, SiO₂ | 0,258 | 0,613 | 538 | 44 |
| 171 | Ba | ₃ | Si | ₇ | O | _{12.5} | N | _{3.3} | Neue Phase | 0,254 | 0,621 | 538 | 100 |
| 172 | Ba | ₁ | Si | ₃ | O | ₅ | N | _{1.33} | Neue Phase, BaSi₂O₅ | 0,260 | 0,619 | 539 | 75 |
| 173 | Ba | ₁ | Si | ₃ | O | _{5.4} | N | _{1.068} | Neue Phase, BaSi₂O₅ | 0,262 | 0,622 | 540 | 73 |
| 174 | Ba | ₃ | Si | ₆ | O | ₁₂ | N | ₂ | Neue Phase, BaSi₂O₅ | 0,258 | 0,591 | 537 | 100 |
| 175 | Ba | ₂ | Si | ₅ | O | ₉ | N | ₂ | Neue Phase | 0,255 | 0,623 | 536 | 100 |
| 415 | Ba | ₃ | Si | ₇ | O | _{12.5} | N | _{3.3} | Neue Phase | 0,252 | 0,629 | 538 | 116 |
| 418 | Ba | ₃ | Si | ₇ | O | _{12.5} | N | _{3.3} | Neue Phase | 0,252 | 0,629 | 538 | 113 |
| 416 | Ba | ₃ | Si | ₆ | O | ₁₂ | N | ₂ | Neue Phase, BaSi₂O₅ | 0,254 | 0,604 | 537 | 112 |
| 419 | Ba | ₃ | Si | ₆ | O | ₁₂ | N | ₂ | Neue Phase, BaSi₂O₅ | 0,252 | 0,593 | 536 | 107 |

**Tabelle 4a**

| *Probe BP--*/*07* | *Einwaagestöchiometrie* | | | | | | | | *Aktivatorkonz. (mol*%*)* | *Exc (nm)* | *x* | *y* | λ*_{Dom} (nm)* | *Rel. Q. E. (*%*)* | *Rel. Helligkeit (*%*)* |
|---|---|---|---|---|---|---|---|---|---|---|---|---|---|---|---|
| *230* | *Ba* | *₁* | *Si* | *_{2,3}* | *O* | *_{4,3}* | *N* | *_{0,9}* | *2* | *400* | *0,254* | *0,624* | *538* | *81* | *54* |
| *230a* | *Ba* | *₁* | *Si* | *_{2,3}* | *O* | *_{4,3}* | *N* | *_{0,9}* | *2* | *400* | *0,254* | *0,630* | *538* | *84* | *76* |
| *231* | *Ba* | *₃* | *Si* | *₆* | *O* | *₁₂* | *N* | *₂* | *2* | *400* | *0,253* | *0,583* | *534* | *80* | *53* |
| *231a* | *Ba* | *₃* | *Si* | *₆* | *O* | *₁₂* | *N* | *₂* | *2* | *400* | *0,250* | *0,592* | *534* | *81* | *63* |
| *232* | *Ba* | *₂* | *Si* | *₅* | *O* | *₉* | *N* | *₂* | *2* | *400* | *0,255* | *0,625* | *538* | *81* | *56* |
| *232a* | *Ba* | *₂* | *Si* | *₅* | *O* | *₉* | *N* | *₂* | *2* | *400* | *0,252* | *0,630* | *538* | *81* | *76* |
| *415* | *Ba* | *₃* | *Si* | *₇* | *O* | *₁₂* | *N* | *_{3,3}* | *2* | *400* | *0,252* | *0,629* | *538* | *97* | *61* |
| *233* | *Ba* | *₂* | *Si* | *₅* | *O* | *₉* | *N* | *₂* | *4* | *400* | *0,268* | *0,629* | *542* | *86* | *74* |
| *233a* | *Ba* | *₂* | *Si* | *₅* | *O* | *₉* | *N* | *₂* | *4* | *400* | *0,265* | *0,634* | *541* | *80* | *89* |
| *236* | *Ba* | *₂* | *Si* | *₅* | *O* | *₉* | *N* | *₂* | *5* | *400* | *0,269* | *0,632* | *542* | *79* | *79* |
| *237* | *Ba* | *₂* | *Si* | *₅* | *O* | *₉* | *N* | *₂* | *10* | *400* | *0,296* | *0,632* | *548* | *63* | *75* |
| *240* | *Ba* | *₃* | *Si* | *₆* | *O* | *₁₂* | *N* | *₂* | *5* | *400* | *0,269* | *0,602* | *541* | *81* | *72* |
| *241* | *Ba* | *₃* | *Si* | *₆* | *O* | *₁₂* | *N* | *₂* | *10* | *400* | *0,296* | *0,619* | *548* | *65* | *76* |
| *244* | *Ba* | *₁* | *Si* | *_{2,3}* | *O* | *_{4,3}* | *N* | *_{0,9}* | *5* | *400* | *0,269* | *0,634* | *542* | *86* | *86* |
| *245* | *Ba* | *₁* | *Si* | *_{2,3}* | *O* | *_{4,3}* | *N* | *_{0,9}* | *10* | *400* | *0,296* | *0,633* | *548* | *69* | *85* |
| *498* | *Ba* | *₃* | *Si* | *₇* | *O* | *₁₂* | *N* | *_{3,3}* | *5* | *400* | *0,272* | *0,633* | *543* | *100* | *82* |
| *499* | *Ba* | *₃* | *Si* | *₇* | *O* | *₁₂* | *N* | *_{3,3}* | *10* | *400* | *0,302* | *0,629* | *549* | *92* | *100* |

**Tabelle 4b**

| Probe BP ---/07 | Einwaagestöchiometrie | | | | | | | | Aktivatorkonz. (mol%) | Exc (nm) | x | y | λ_{Dom} (nm) | Rel. Q.E. (%) | Rel. Helligkeit (%) |
|---|---|---|---|---|---|---|---|---|---|---|---|---|---|---|---|
| 230 | Ba | ₁ | Si | _{2,3} | O | _{4,3} | N | _{0,9} | 2 | 460 | 0,259 | 0,630 | 540 | 78 | 37 |
| 230a | Ba | ₁ | Si | _{2,3} | 0 | _{4,3} | N | _{0,9} | 2 | 460 | 0,259 | 0,636 | 540 | 86 | 63 |
| 231 | Ba | ₃ | Si | ₆ | O | ₁₂ | N | ₂ | 2 | 460 | 0,256 | 0,628 | 539 | 81 | 34 |
| 231a | Ba | ₃ | Si | ₆ | O | ₁₂ | N | ₂ | 2 | 460 | 0,257 | 0,633 | 539 | 86 | 45 |
| 232 | Ba | ₂ | Si | ₅ | O | ₉ | N | ₂ | 2 | 460 | 0,260 | 0,629 | 540 | 75 | 39 |
| 232a | Ba | ₂ | Si | ₅ | O | ₉ | N | ₂ | 2 | 460 | 0,256 | 0,363 | 539 | 81 | 63 |
| 233 | Ba | ₂ | Si | ₅ | O | ₉ | N | ₂ | 4 | 460 | 0,273 | 0,633 | 543 | 85 | 58 |
| 233a | Ba | ₂ | Si | ₅ | O | ₉ | N | ₂ | 4 | 460 | 0,269 | 0,639 | 543 | 85 | 87 |
| 236 | Ba | ₂ | Si | ₅ | O | ₉ | N | ₂ | 5 | 460 | 0,274 | 0,636 | 544 | 84 | 74 |
| 237 | Ba | ₂ | Si | ₅ | O | ₉ | N | ₂ | 10 | 460 | 0,300 | 0,633 | 549 | 69 | 86 |
| 240 | Ba | ₃ | Si | ₆ | O | ₁₂ | N | ₂ | 5 | 460 | 0,273 | 0,634 | 543 | 96 | 62 |
| 241 | Ba | ₃ | Si | ₆ | O | ₁₂ | N | ₂ | 10 | 460 | 0,300 | 0,633 | 549 | 88 | 94 |
| 244 | Ba | ₁ | Si | _{2,3} | O | _{4,3} | N | _{0,9} | 5 | 460 | 0,274 | 0,638 | 544 | 91 | 81 |
| 245 | Ba | ₁ | Si | _{2,3} | O | _{4,3} | N | _{0,9} | 10 | 460 | 0,301 | 0,635 | 549 | 78 | 100 |
| 498 | Ba | ₃ | Si | ₇ | O | ₁₂ | N | _{3,3} | 5 | 460 | 0,272 | 0,633 | 543 | 100 | 75 |
| 499 | Ba | ₃ | Si | ₇ | O | ₁₂ | N | _{3,3} | 10 | 460 | 0,302 | 0,629 | 549 | 96 | 94 |

**Tab. 5**

| *Probennummer* | *Ansatzstöchiometrie* | *λ_{Exc} (nm)* | *x* | *y* |
|---|---|---|---|---|
| *BP 234*/*07* | *(Ba_{0,99}EU_{0,01})₂Si₅O₉N₂* | *400* | *0,25* | *0,62* |
| *BP 319*/*07* | *(Ba_{0,98}Eu_{0,01}Ce_{0,01}Si₅O₉N₂* | *400* | *0,25* | *0,62* |
| *BP 319*/*07* | *(Ba_{0,98}Eu_{0,01}Ce_{0,01})₂Si₅O₉N₂* | *370* | *0,25* | *0,62* |
| *BP 320*/*07* | *(Ba_{0,98}Ce_{0,02})₂Si₅O₉N₂* | *370* | *0,18* | *0,15* |
| *BP 320*/*07* | *(Ba_{0,98}Ce_{0,02})₂Si₅O₉N₂* | *338* | *0,18* | *0,12* |
| *BP 320*/*07* | *(Ba_{0,98}Ce_{0,02})₂Si₅O₉N₂* | *290* | *0,18* | *0,12* |
| *BP 322*/*07* | *(88_{0,95}Tb_{0,05})₂Si₅O₉N₂* | *254* | *0,21* | *0,61* |
| *BP 323*/*07* | *(Ba_{0,98}Eu_{0,01}Mn_{0,01})₂Si₅O₉N₂* | *400* | *0,25* | *0,62* |
| *BP 323*/*07* | *(Ba_{0,98}EU_{0,01}Mn_{0,01})₂Si₅O₉N₂* | *370* | *0,25* | *0,62* |

## Patentansprüche

1. Temperaturstabiler Leuchtstoff aus dem M-Si-O-N System, mit einem Kation M und einem Aktivator D, wobei M durch Ba oder Sr allein oder in Mischung repräsentiert ist und ggf. zusätzlich mit mindestens einem weiteren Element aus der Gruppe Ca, Mg, Zn, Cu kombiniert ist, wobei der Leuchtstoff mit Eu oder Ce oder Tb allein oder in Mischung, ggf. in Kodotierung mit Mn oder Yb, aktiviert ist, wobei der Aktivator D das Kation M teilweise ersetzt, wobei der Leuchtstoff grün emittiert, **dadurch gekennzeichnet, dass** der Leuchtstoff aus der Ansatzstöchiometrie MO-Si02- SiN_{4/3} hergestellt ist mit einem gegenüber dem bekannten Leuchtstoff MSi2O2N2:D erhöhten Sauerstoffgehalt, wobei MO eine oxidische Verbindung von M ist, wobei der Leuchtstoff im wesentlichen die Stöchiometrie MₐSi_{b+3c}O_{a+2b}N_{4c} hat, wobei gilt: das Verhältnis b:c ist b:c = 4,8 bis 8,0 und wobei gilt: das Verhältnis a:C ist a:c = 3,5 bis 5,5.

2. Leuchtstoff nach Anspruch 1, **dadurch gekennzeichnet, dass** der Anteil MO über eine Verbindung MC03 eingebracht worden ist.

3. Leuchtstoff nach Anspruch 1, **dadurch gekennzeichnet, dass** gilt: M = Ba allein oder überwiegend, d.h. zu mehr als 50%.

4. Leuchtstoff nach Anspruch 2, **dadurch gekennzeichnet, dass** das Verhältnis MC03:Si02 der Ansatzmischung zwischen 1:1,5 und 1:2 beträgt, Randwerte eingeschlossen.

5. Leuchtstoff nach Anspruch 4, **dadurch gekennzeichnet, dass** der SiN_{4/3}-Anteil der Ansatzmischung im System MC03 - Si02 - SiN4/3 mindestens 15 % beträgt und insbesondere höchstens 55 % beträgt.

6. Leuchtstoff nach Anspruch 5, **dadurch gekennzeichnet, dass** der SiN_{4/3}-Anteil mindestens 20% beträgt und insbesondere höchstens 30 % beträgt, insbesondere wobei der Leuchtstoff der Ansatzstöchiometrie Ba2Si4,6O8,6N1,8 oder Ba2Si5O9N2 oder Ba3Si7O12N3,3 folgt, wobei 2% Eu für Ba als Dotierung verwendet wird.

7. Leuchtstoff nach Anspruch 1, **dadurch gekennzeichnet, dass** der Leuchtstoff selbst die Stöchiometrie M2,5Si6O11,5N2 aufweist, wobei insbesondere M = Ba allein oder überwiegend mit mehr als 50 Mol.-%.

8. Leuchtstoff nach Anspruch 1, **dadurch gekennzeichnet, dass** b:c im Bereich 5 bis 6 und gleichzeitig a:c im Bereich 3,5 bis 4 liegt.

9. Leuchtstoff nach Anspruch 1, **dadurch gekennzeichnet, dass** der Leuchtstoff im wesentlichen durch eine Ansatzstöchiometrie hergestellt ist, die in einem Quadrat mit den folgenden Eckpunkten (1) bis (4) liegt:
(1) SiO2: SiN4/3 : BaC03 = 0,525 : 0,25 : 0,225 (entspricht Ba1.8Si6.2O10.2N2.67);
(2) SiO2 : SiN4/3 : BaC03 = 0,425 : 0,25 : 0,325 (entspricht Ba2.6Si5.4O9.4N2.67);
(3) SiO2 : SiN4/3 : BaCO3 = 0,475 : 0,15 : 0,375 (entspricht Ba3Si5O10.6N1.6);
(43) Si02 : SiN4/3 : BaC03 = 0,575 : 0,15 : 0,275 (entspricht Ba2.2Si5.8O11.4N 1.6)
wobei 2% Eu für Ba als Dotierung verwendet wird.

10. Lichtquelle mit einem Leuchtstoff nach einem der vorhergehenden Ansprüche.

11. Lichtquelle nach Anspruch 9, **dadurch gekennzeichnet, dass** die Lichtquelle eine LED ist.

12. Verfahren zur Herstellung eines Leuchtstoff aus dem M-Si-O-N System gemäß Anspruch 1, mit einem Kation M und einem Aktivator D, wobei M durch Ba oder Sr allein oder in Mischung repräsentiert ist und ggf. zusätzlich mit mindestens einem weiteren Element aus der Gruppe Ca, Mg, Zn, Cu kombiniert ist, wobei der Leuchtstoff mit Eu oder Ce oder Tb allein oder in Mischung, ggf. in Kodotierung mit Mn oder Yb, aktiviert ist, wobei der Aktivator D das Kation M teilweise ersetzt, wobei der Leuchtstoff grün emittiert, wobei der Leuchtstoff aus der Ansatzstöchiometrie MO-Si02- SiN_{4/3} hergestellt ist mit einem gegenüber dem bekannten Leuchtstoff MSi2O2N2:D erhöhten Sauerstoffgehalt, wobei MO eine oxidische Verbindung von M ist, wobei der Leuchtstoff im wesentlichen die Stöchiometrie MₐSi_{b+3c}O_{a+2b}N_{4c} hat, **gekennzeichnet durch** folgende Verfahrensschritte:
a) Homogenisieren der Substanzen MC03, Si02, Si3N4 und des Vorläufers der Aktivierungssubstanz, insbesondere ein Oxid von D, bevorzugt Eu2O3 allein oder in Kombination mit Yb-Oxid, über mehrere Stunden, insbesondere 2 bis 6 Stunden;
b) Mischen der Substanzen unter Beachtung eines Verhältnisses MO:SiO2 zwischen 1:1,5 und 1:2, Randwerte eingeschlossen;
c) erstes Glühen der Ansatzmischung unter reduzierenden Bedingungen, bei einer Temperatur von 1200 bis 1400 °C, für mehrere Stunden, insbesondere 4 bis 10 Stunden lang;
d) ggf. Mahlen des Glühkuchens;
e) ggf. zweites Glühen unter reduzierenden Bedingungen, bei einer Temperatur von 850°C bis 1450°C.

13. Verfahren nach Anspruch 12, **dadurch gekennzeichnet, dass** der Anteil MO über eine Verbindung MC03 eingebracht worden ist.

14. Verfähren nach Anspruch 13, **dadurch gekennzeichnet. dass** das Verhältnis MC03:Si02 der Ansatzmischung zwischen 1:1,5 und 1:2 beträgt, Randwerte eingeschlossen.

15. Verfahren nach Anspruch 14, **dadurch gekennzeichnet, dass** der SiN_{4/3}-Anteil der Ansatzmischung in der Darstellung des System als MC03 - Si02 - SiN4/3 mindestens 15 % beträgt und insbesondere höchstens 55 % beträgt.

16. Verfahren nach Anspruch 15, **dadurch gekennzeichnet, dass** der SiN_{4/3}-Anteil höchstens 30 % beträgt.

17. Verfahren nach Anspruch 12, **dadurch gekennzeichnet, dass** ein Schmelzmittel verwendet wird, bevorzugt ein Chlorid oder Karbonat, mit einem Anteil von höchstens 5 Gew.-% , bezogen auf die Ansatzstöchiometrie ohne Schmelzmittel.

## Claims

1. Thermally stable phosphor made of the M-Si-O-N system, having a cation M and an activator D, M being represented by Ba or Sr alone or as a mixture and optionally also being combined with at least one other element from the group Ca, Mg, Zn, Cu, the phosphor being activated with Eu or Ce or Tb alone or as a mixture, optionally in codoping with Mn or Yb, the activator D partially replacing the cation M, the phosphor emitting in green, **characterized in that** the phosphor is produced from the charge stoichiometry MO-SiO₂-SiN_{4/3} with an increased oxygen content relative to the known phosphor MSi₂O₂N₂:D, where MO is an oxidic compound of M, the phosphor essentially has the stoichiometry MₐSi_{b+3c}O_{a+2b}N_{4c}, where: the ratio b:c is b:c = 4.8 to 8.0 and where: the ratio a:c is a:c = 3.5 to 5.5.

2. Phosphor according to Claim 1, **characterized in that** the component MO was introduced by means of a compound MCO₃.

3. Phosphor according to Claim 1, **characterized in that** M = Ba alone or predominantly, i.e. more than 50%.

4. Phosphor according to Claim 2, **characterized in that** the MCO₃ : SiO₂ ratio of the charge mixture is between 1:1.5 and 1:2, including the endpoint values.

5. Phosphor according to Claim 4, **characterized in that** the SiN_{4/3} component of the charge mixture in the system MCO₃-SiO₂-SiN_{4/3} is at least 15% and in particular at most 55%.

6. Phosphor according to Claim 5, **characterized in that** the SiN_{4/3} component is at least 20% and in particular at most 30% in particular the phosphor following the charge stoichiometry Ba₂Si_{4.6}O_{8.6}N_{1.8} or Ba₂Si₅O₉N₂ or Ba₃Si₇O₁₂N_{3.3}, 2% EU being used as doping for Ba.

7. Phosphor according to Claim 1, **characterized in that** the phosphor itself has the stoichiometry M_{2.5}Si₆O_{11.5}N₂, where in particular M = Ba alone or predominantly at more than 50 mol%.

8. Phosphor according to Claim 1, **characterized in that** b:c lies in the range of from 5 to 6 and at the same time a:c lies in the range of from 3.5 to 4.

9. Phosphor according to Claim 1, **characterized in that** the phosphor is essentially produced by a charge stoichiometry which lies in a square with the following corners (1) to (4):
(1)SiO₂: SiN_{4/3}: BaCO₃ = 0.525: 0.25: 0.225 (corresponding to Ba_{1.8}Si_{6.2}O_{10.2}N_{2.67});
(2)SiO₂: SiN_{4/3}: BaCO₃ = 0.425: 0.25: 0.325 (corresponding to Ba_{2.6}Si_{5.4}O_{9.4}N_{2.67}) ;
(3)SiO₂: SiN_{4/3}: BaCO₃ = 0.475: 0.15: 0.375 (corresponding to Ba₃Si₅O_{10.6}N_{1.6}) ;
(4)SiO₂: SiN_{4/3}: BaCO₃ = 0.575: 0.15: 0.275 (corresponding to Ba_{2.2}Si_{5.8}O_{11.4}N_{1.6}),
2% Eu being used as doping for Ba

10. Light source having a phosphor according to one of the preceding claims.

11. Light source according to Claim 9, **characterized in that** the light source is an LED.

12. Method for producing a phosphor made of the M-Si-O-N system according to Claim 1, having a cation M and an activator D, M being represented by Ba or Sr alone or as a mixture and optionally also being combined with at least one other element from the group Ca, Mg, Zn, Cu, the phosphor being activated with Eu or Ce or Tb alone or as a mixture, optionally in codoping with Mn or Yb, the activator D partially replacing the cation M, the phosphor emitting in green, the phosphor being produced from the charge stoichiometry MO-SiO₂-SiN_{4/3} with an increased oxygen content relative to the known phosphor MSi₂O₂N₂:D, where MO is an oxidic compound of M, the phosphor essentially having the stoichiometry MₐSi_{b+3c}O_{a+2b}N_{4c}, **characterized by** the following method steps:
a) homogenizing the substances MCO₃, SiO₂, Si₃N₄ and the precursor of the activation substance, in particular an oxide of D, preferably Eu₂O₃ alone or in combination with Yb oxide, for several hours, in particular from 2 to 6 hours;
b) mixing the substances while maintaining a MCO₃:SiO₂ ratio of between 1:1.5 and 1:2, including the endpoint values;
c) first annealing of the charge mixture under reducing conditions, at a temperature of from 1200 to 1400°C, for several hours, in particular for from 4 to 10 hours;
d) optionally grinding the anneal cake;
e) optionally second annealing under reducing conditions, at a temperature of from 850°C to 1450°C.

13. Method according to Claim 12, **characterized in that** the component MO was introduced by means of a compound MCO₃.

14. Method according to Claim 13, **characterized in that** the MCO₃:SiO₂ ratio of the charge mixture is between 1:1.5 and 1:2, including the endpoint values.

15. Method according to Claim 14, **characterized in that** the SiN_{4/3} component of the charge mixture in the preparation of the system MCO₃-SiO₂-SiN_{4/3} is at least 15% and in particular at most 55%.

16. Method according to Claim 15, **characterized in that** the SiN_{4/3} component is at most 30%.

17. Method according to Claim 12, **characterized in that** a fluxing agent is used, preferably a chloride or carbonate, with a proportion of at most 5 wt% expressed in terms of the charge stoichiometry without a fluxing agent.

## Revendications

1. Substance luminescente stable à la température, constituée du système M-Si-O-N, comprenant un cation M et un activateur D, M étant représenté par Ba ou Sr à titre unique ou en mélange et étant, de manière facultative, en outre combiné avec au moins un autre élément choisi parmi le groupe comprenant Ca, Mg, Zn, Cu, la substance luminescente étant activée avec Eu ou Ce ou Tb à titre unique ou en mélange, de manière facultative avec Mn ou Yb à titre de codopant, l'activateur D remplaçant en partie le cation M, la substance luminescente émettant dans le vert, **caractérisée en ce que** la substance luminescente est réalisée à partir de la stoechiométrie de préparation MO-SiO₂-SiN_{4/3} possédant une teneur en oxygène supérieure à celle de la substance luminescente connue MSi₂O₂N₂:D, MO représentant un composé oxydé de M, la substance luminescente possédant essentiellement la stoechiométrie MₐSi_{b+3c}O_{a+2b}N_{4c}, en respectant, pour le rapport b:c, l'équation b:c = 4,8 à 8,0, et pour le rapport a:c, l'équation a:c = 3,5 à 5,5.

2. Substance luminescente selon la revendication 1, **caractérisée en ce que** la fraction MO a été incorporée via un composé MCO₃.

3. Substance luminescente selon la revendication 1, **caractérisée en ce que** M représente du baryum à titre unique ou à titre principal, c'est-à-dire à concurrence de plus de 50 %.

4. Substance luminescente selon la revendication 2, **caractérisée en ce que** le rapport MCO₃:SiO₂ du mélange de préparation s'élève entre 1:1,5 et 1:2, valeurs limites comprises.

5. Substance luminescente selon la revendication 4, **caractérisée en ce que** la fraction SiN_{4/3} dans le mélange de préparation dans le système MCO₃-SiO₂-SiN_{4/3} représente au moins 15 % et en particulier une valeur maximale de 55%.

6. Substance luminescente selon la revendication 5, **caractérisée en ce que** la fraction SiN_{4/3} représente au moins 20 % et en particulier au maximum 30 %, en particulier dans laquelle la substance luminescente respecte la stoechiométrie de préparation Ba₂Si_{4,6}O_{8,6}N_{1,8} ou Ba₂Si₅O₉N₂ ou Ba₃Si₇O₁₂N_{3,3}, du Eu à 2 % étant utilisé comme dopant pour Ba.

7. Substance luminescente selon la revendication 1, **caractérisée en ce que** la substance luminescente elle-même présente la stoechiométrie M_{2,5}Si₆O_{11,5}N₂, dans laquelle, en particulier M représente Ba uniquement ou à titre principal à concurrence de plus de 50 moles %.

8. Substance luminescente selon la revendication 1, **caractérisée en ce que** b:c se situe dans la plage de 5 à 6 et de manière simultanée a:c se situe dans la plage de 3,5 à 4.

9. Substance luminescente selon la revendication 1, **caractérisée en ce que** la substance luminescente est préparée essentiellement via une stoechiométrie de préparation qui se situe dans un carré possédant les sommets (1) à (4) indiqués ci-après :
(1) SiO₂: Si_{4/3}: BaCO₃ = 0,525 : 0,25 : 0,225 (ce qui correspond à Ba_{1,8}Si_{6,2}O_{10,2}N_{2,67}) ;
(2) SiO₂: Si_{4/3}: BaCO₃ = 0,425: 0,25: 0,325 (ce qui correspond à Ba_{2,6}Si_{5,4}O_{9,4}N_{2,67}) ;
(3) SiO₂: Si_{4/3}: BaCO₃ = 0,475: 0,15: 0,375 (ce qui correspond à Ba₃Si₅O_{10,6}N_{1,6}) ;
(4) SiO₂: Si_{4/3}: BaCO₃ = 0,575: 0,15: 0,275 (ce qui correspond à Ba_{2,2}Si_{5,8}O_{11,4}N_{1,6}) ;
en utilisant du Eu à 2 % comme dopant pour Ba.

10. Source lumineuse comprenant une substance luminescente selon l'une quelconque des revendications précédentes.

11. Source lumineuse selon la revendication 9, **caractérisée en ce que** la source lumineuse est une LED.

12. Procédé pour la fabrication d'une substance luminescente constituée du système M-Si-O-N selon la revendication 1, comprenant un cation M et un activateur D, M étant représenté par Ba ou Sr à titre unique ou en mélange et étant, de manière facultative, en outre combiné avec au moins un autre élément choisi parmi le groupe comprenant Ca, Mg, Zn, Cu, la substance luminescente étant activée avec Eu ou Ce ou Tb à titre unique ou en mélange, de manière facultative avec Mn ou Yb à titre de codopant, l'activateur D remplaçant en partie le cation M, la substance luminescente émettant dans le vert, la substance luminescente étant réalisée à partir de la stoechiométrie de préparation MO-SiO₂-SiN_{4/3} avec une teneur en oxygène supérieure à celle de la substance luminescente connue MSi₂O₂N₂:D, MO représentant un composé oxydé de M, la substance luminescente possédant essentiellement la stoechiométrie MₐSi_{b+3c}O_{a+2b}N_{4c}, **caractérisé par** les étapes opératoires suivantes :
a) l'homogénéisation des substances MCO₃, SiO₂, Si₃N₄ et du précurseur de la substance d'activation, en particulier un oxyde de D, de préférence Eu₂O₃ seul ou en combinaison avec un oxyde de Yb, pendant plusieurs heures, en particulier pendant 2 à 6 heures ;
b) le mélange des substances en respectant un rapport MO:SiO₂ entre 1:1,5 et 1:2, valeurs limites comprises.
c) une première calcination du mélange de préparation dans des conditions de réduction, à une température de 1200 à 1400 °C, pendant plusieurs heures, en particulier pendant 4 à 10 heures ;
d) de manière facultative, le broyage du gâteau de calcination ;
e) de manière facultative une deuxième calcination dans des conditions de réduction, à une température de 850 °C à 1450 °C.

13. Procédé selon la revendication 12, **caractérisé en ce que** la fraction MO a été incorporée via un composé MCO₃.

14. Procédé selon la revendication 13, **caractérisé en ce que** le rapport MCO₃:SiO₂ du mélange de préparation s'élève entre 1:1,5 et 1:2, valeurs limites comprises.

15. Procédé selon la revendication 14, **caractérisé en ce que** la fraction SiN_{4/3} du mélange de préparation dans la représentation du système sous la forme MCO₃-SiO₂-SiN_{4,3} représente au moins 15 % et en particulier une valeur maximale de 55 %.

16. Procédé selon la revendication 15, **caractérisé en ce que** la fraction SiN_{4,3} représente au maximum 30 %.

17. Procédé selon la revendication 12, **caractérisé en ce qu'**on utilise un fondant, de préférence un chlorure ou un carbonate, en une fraction maximale de 5 % en poids rapporté à la stoechiométrie de préparation en l'absence de fondant.
